# EUROPEAN PATENT APPLICATION

(11) **EP 4 625 104 A1**
(43) Date of publication of application: **01.10.2025**
(21) Application number: 25700407.7
(22) Date of filing: 07.01.2025
(51) Int. Cl.: G06F 1/16, H05K 1/14

(54) **ELECTRONIC DEVICE COMPRISING SENSOR**

(30) Priority: 05.02.2024 KR 20240017422; 27.02.2024 KR 20240028228
(71) Applicant: Samsung Electronics Co., Ltd., Suwon-si, Gyeonggi-do 16677 (KR)
(72) Inventor: KIM, Byoungjun, Suwon-si, Gyeonggi-do 16677 (KR); KANG, Jeongho, Suwon-si, Gyeonggi-do 16677 (KR); KIM, Namwoo, Suwon-si, Gyeonggi-do 16677 (KR); KIM, Minho, Suwon-si, Gyeonggi-do 16677 (KR); KIM, Sunglak, Suwon-si, Gyeonggi-do 16677 (KR); AHN, Jaeuk, Suwon-si, Gyeonggi-do 16677 (KR); JANG, Gyudae, Suwon-si, Gyeonggi-do 16677 (KR); CHUN, Jinwook, Suwon-si, Gyeonggi-do 16677 (KR); CHOI, Junyoung, Suwon-si, Gyeonggi-do 16677 (KR); SHIM, Jaesung, Suwon-si, Gyeonggi-do 16677 (KR)
(74) Representative: Walaski, Jan Filip
(86) International application number: PCT/KR2025/000344
(87) International publication number: WO 2025/170210

(57) **Abstract**

An electronic device according to an embodiment of the disclosure may include a first housing; a second housing movably coupled to the first housing; a first support bracket and first printed circuit board disposed in the first housing; a second printed circuit board disposed in the second housing; a sensor structure connected to the first support bracket at one end and connected to the second printed circuit board at the other end; and a second support bracket configured to support the sensor structure, wherein the sensor structure may include a bending sensor element including a dielectric layer and protective layers protecting the dielectric layer, and configured to measure an angle of the sensor structure; and a flexible printed circuit board configured to electrically connect the first printed circuit board and the second printed circuit board, and having at least a portion coupled to the bending sensor element.

## Description

### [Technical Field]

The disclosure relates to an electronic device including a sensor.

### [Background Art]

Electronic devices (e.g., rollable electronic devices) may include a first housing, a second housing, and a flexible display. The second housing may be coupled to the first housing so as to be movable with respect to the first housing. The flexible display may expand or reduce a display area displayed to the outside according to the movement of the second housing with respect to the first housing.

The above information may be provided as the related art for the purpose of helping to understand the disclosure. None of the above description may be used for being claimed as the prior art related to the disclosure or determining the prior art.

### [Disclosure of Invention]

### [Solution to Problem]

According to an embodiment of the disclosure, an electronic device may include a first housing, a second housing, a first support bracket, a first printed circuit board, a second printed circuit board, a sensor structure, and a second support bracket.

In an embodiment, the second housing may be movably coupled to the first housing.

In an embodiment, the first support bracket may be disposed in the first housing.

In an embodiment, the first printed circuit board may be disposed in the first housing.

In an embodiment, the second printed circuit board may be disposed in the second housing.

In an embodiment, the sensor structure may be connected to the first support bracket at one end and be connected to the second printed circuit board at the other end.

In an embodiment, the second support bracket may support the sensor structure.

In an embodiment, the sensor structure may include a bending sensor element and a flexible printed circuit board.

In an embodiment, the bending sensor element may include a dielectric layer and a protective layer protecting the dielectric layer and measure an angle of the sensor structure.

In an embodiment, the flexible printed circuit board may electrically connect the first printed circuit board and the second printed circuit board and have at least a portion coupled to the bending sensor element.

In an embodiment, the electronic device may include a processor disposed in the second printed circuit board.

In an embodiment, the processor may be configured to calculate a distance in which the second housing moves in a longitudinal direction of the electronic device with respect to the first housing based on the angle of the sensor structure.

### [Brief Description of Drawings]

FIG. 1 is a block diagram illustrating an electronic device within a network environment according to an embodiment.
FIGS. 2A and 2B are diagrams illustrating an electronic device in a slide-in state according to an embodiment.
FIGS. 3A and 3B are diagrams illustrating an electronic device in a slide-out state according to an embodiment.
FIG. 4 is an exploded perspective view illustrating an electronic device according to an embodiment.
FIGS. 5A, 5B, and 5C are cross-sectional views illustrating an electronic device according to an embodiment.
FIGS. 6A and 6B are diagrams illustrating an electronic device according to an embodiment.
FIG. 7 is a diagram illustrating a first support bracket, a printed circuit board, a sensor structure, and a second support bracket according to an embodiment.
FIGS. 8A and 8B are diagrams illustrating a sensor structure according to an embodiment.
FIGS. 9A and 9B are conceptual diagrams illustrating an angle of a bending sensor element according to an embodiment.
FIGS. 10A, 10B, and 10C are diagrams illustrating a second support bracket according to an embodiment.
FIGS. 11A and 11B are diagrams illustrating a movement of a second support bracket according to an embodiment.
FIG. 12 is a diagram illustrating a second printed circuit board and a sensor structure according to an embodiment.
FIGS. 13A and 13B are diagrams illustrating a sensor structure according to an embodiment.
FIG. 14 is a diagram illustrating a sensor structure according to an embodiment.
FIG. 15 is a diagram illustrating an electronic device according to an embodiment.
FIG. 16 is a block diagram illustrating an electronic device according to an embodiment.
FIG. 17 is a diagram illustrating an electronic device according to a comparative example.

### [Mode for the Invention]

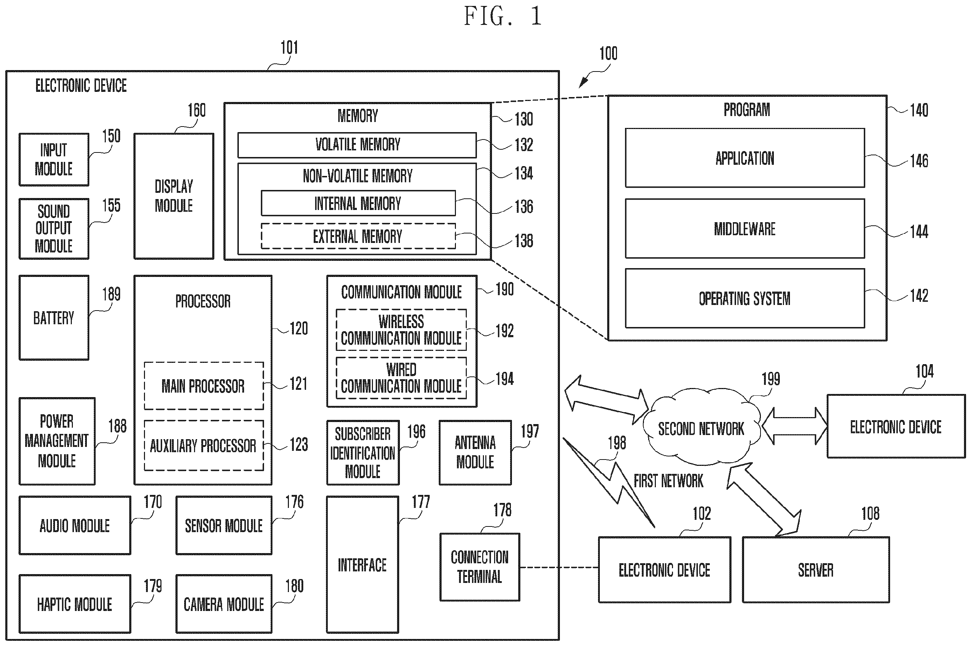

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). The electronic device 101 may communicate with the electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. At least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). The auxiliary processor 123 (e.g., an image signal processor or a communication processor) may be implemented as part of another component (e.g., the camera module 180 or the communication module 190) functionally related to the auxiliary processor 123. The auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include a touch sensor adapted to detect a touch, or a pressure sensor adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., an electronic device 102) directly (e.g., wired) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wired) or wirelessly. The interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). The connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). The wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. The antenna module 197 may include an antenna including a radiating element composed of a conductive material or a conductive pattern formed in or on a substrate (e.g., a printed circuit board (PCB)). The antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. The mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low latency services using, e.g., distributed computing or mobile edge computing. In another embodiment, the external electronic device 104 may include an internet-of-things (IoT) device. The server 108 may be an intelligent server using machine learning and/or a neural network. The external electronic device 104 or the server 108 may be included in the second network 199. The electronic device 101 may be applied to intelligent services (e.g., smart home, smart city, smart car, or healthcare) based on 5G communication technology or IoT-related technology.

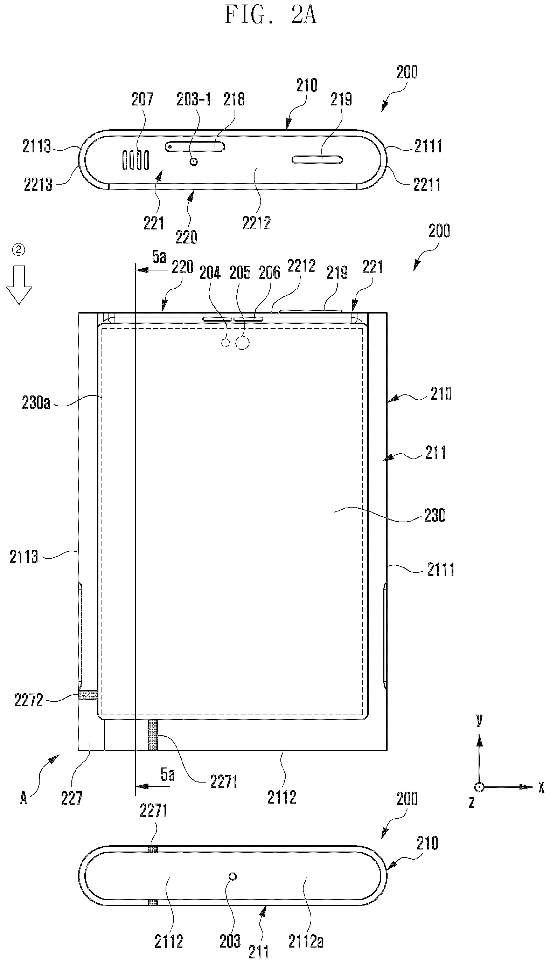

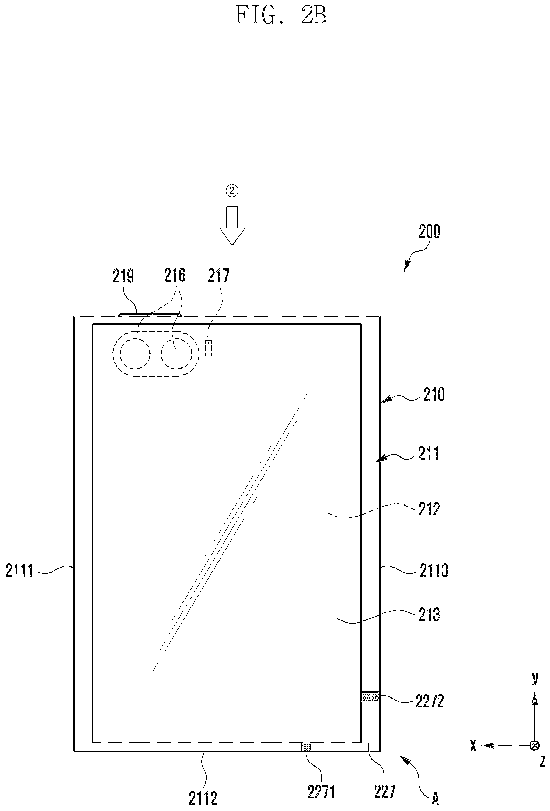

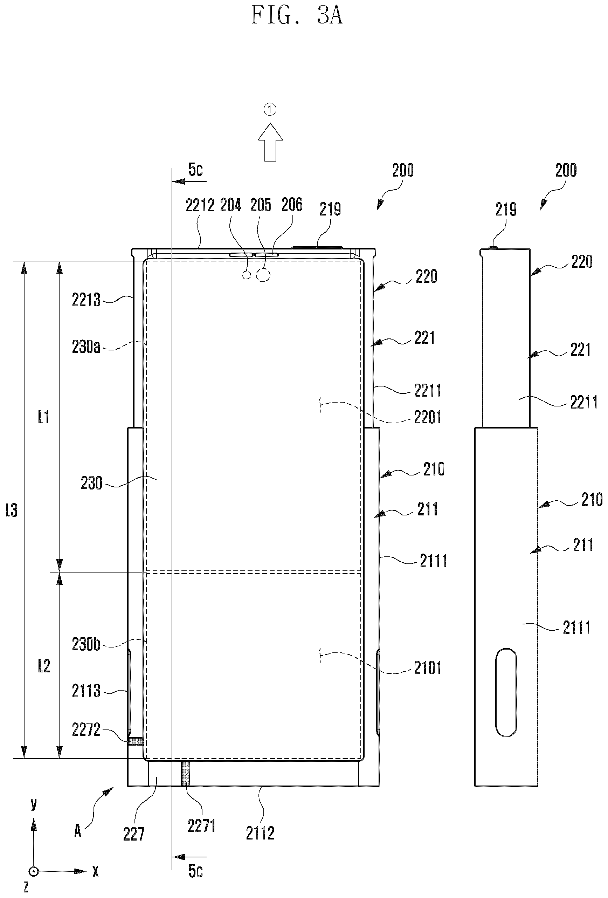

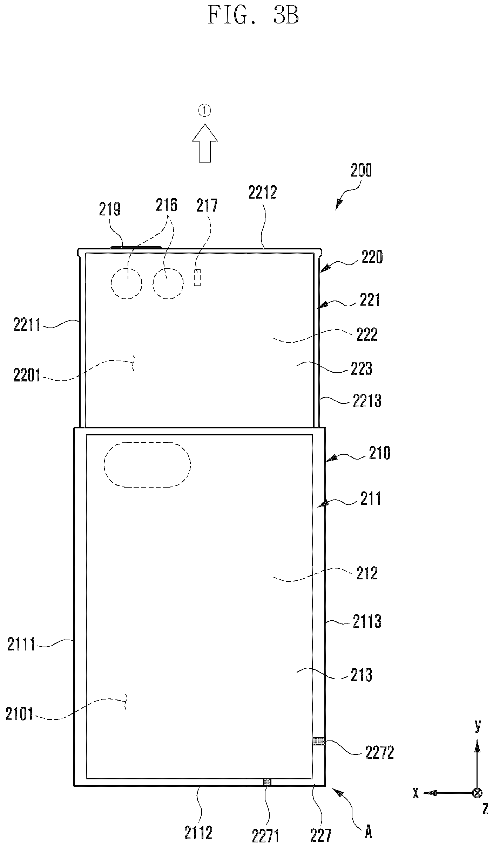

FIGS. 2A and 2B are diagrams illustrating a front surface and a rear surface of an electronic device in a slide-in state. FIGS. 3A and 3B are diagrams illustrating a front surface and a rear surface of an electronic device in a slide-out state.

An electronic device 200 of FIGS. 2A and 3B may mean the electronic device 101 of FIG. 1 or may include at least some of components of the electronic device of FIG. 1.

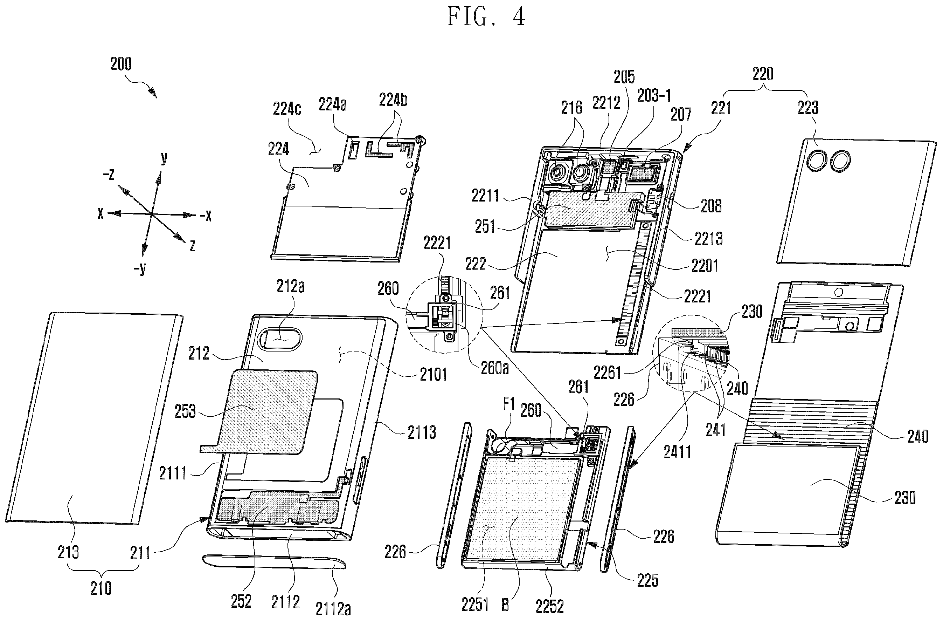

With reference to FIGS. 2A and 3B, the electronic device 200 may include a first housing 210, a second housing 220 slidably coupled in a designated direction (e.g., direction ① or direction ②) (e.g., ± y-axis direction) from the first housing 210, and a rollable display 230 (e.g., flexible display, expandable display, or stretchable display) disposed to be supported by at least a portion of the first housing 210 and the second housing 220. The second housing 220 may be slidably coupled to the first housing 210 so that it may be withdrawn in a first direction (direction ①) or retracted in a second direction (direction ②) opposite to the first direction (direction ①) relative to the first housing 210. As at least a portion of the second housing 220 is received in at least a portion of a first space 2101 formed through the first housing 210, the electronic device 200 may be changed to a slide-in state (e.g., retracted state). As at least a portion of the second housing 220 is moved outwardly (e.g., direction ①) from the first space 2101, the electronic device 200 may be changed to a slide-out state (e.g., withdrawn state). The electronic device 200 may include a support member (e.g., a support member 240 of FIG. 4) (e.g., bendable member, bendable support member, multi-joint hinge module, or multi-bar assembly) that forms substantially the same plane as that of at least a portion of the second housing 220 in the slide-out state, and received in a bending manner at least partially into the first space 2101 of the first housing 210 in the slide-in state. At least a portion of the rollable display 230 may be disposed in such a manner that it is attached to at least a portion of the second housing 220. At least a portion of the remaining portions of the rollable display 230 may be attached to the support member (e.g., the support member 240 of FIG. 4). At least a portion of the rollable display 230 may be disposed to be invisible from the outside by being received in a bendable manner into the first space 2101 of the first housing 210 while being supported by the support member (e.g., the support member 240 of FIG. 4) in a slide-in state. At least a portion of the rollable display 230 may be disposed to be visible from the outside while being supported by the support member (e.g., a support member 240 of FIG. 4) that forms at least partially the same plane as that of the second housing 220 in a slide-out state.

The electronic device 200 may include a first housing 210 including a first lateral member 211 and a second housing 220 including a second lateral member 221. The first lateral member 211 may include a first side surface 2111 having a first length along a designated direction (e.g., ± y-axis direction), a second side surface 2112 extended to have a second length shorter than the first length along a direction (e.g., x-axis direction) substantially perpendicular to the first side surface 2111, and a third side surface 2113 extended substantially parallel to the first side surface 2111 from the second side surface 2112 and having the first length. The first lateral member 211 may be at least partially made of a conductive member (e.g., metal). The first lateral member 211 may be formed by coupling a conductive member and a non-conductive member (e.g., polymer). The first housing 210 may include a first extension member 212 extended from at least a portion of the first lateral member 211 to at least a portion of the first space 2101. The first extension member 212 may be formed integrally with the first lateral member 211. The first extension member 212 may be formed separately from the first lateral member 211 and be structurally coupled with the first lateral member 211.

The second lateral member 221 may include a fourth side surface 2211 corresponding at least partially to the first side surface 2111 and having a third length, a fifth side surface 2212 extended from the fourth side surface 2211 in a direction substantially parallel to the second side surface 2112 and having a fourth length shorter than the third length, and a sixth side surface 2213 extended from the fifth side surface 2212 to correspond to the third side surface 2113 and having a third length. The second lateral member 221 may be at least partially made of a conductive member (e.g., metal). The second lateral member 221 may be formed by coupling a conductive member and a non-conductive member (e.g., polymer). At least a portion of the second lateral member 221 may include a second extension member 222 extending to at least a portion of the second space 2201 of the second housing 220. The second extension member 222 may be formed integrally with the second lateral member 221. The second extension member 222 may be formed separately from the second lateral member 221 and be structurally coupled to the second lateral member 221.

The first side surface 2111 and the fourth side surface 2211 may be slidably coupled with respect to each other. The third side surface 2113 and the sixth side surface 2213 may be slidably coupled with respect to each other. In the slide-in state, the fourth side surface 2211 may overlap the first side surface 2111 to be disposed substantially invisibly from the outside. In the slide-in state, the sixth side surface 2213 may overlap the third side surface 2113 to be disposed substantially invisibly from the outside. At least a portion of the fourth side surface 2211 and the sixth side surface 2213 may be disposed at least partially visibly from the outside in the slide-in state. In an embodiment, in the slide-in state, the second extension member 222 may overlap the first extension member 212 to be disposed substantially invisibly from the outside. The second extension member 222 may be disposed at least partially visibly from the outside in the slide-in state.

The first housing 210 may include a first rear cover 213 coupled with at least a portion of the first lateral member 211. The first rear cover 213 may be disposed in a manner in which it couples with at least a portion of the first extension member 212. The first rear cover 213 may be formed integrally with the first lateral member 211. The first rear cover 213 may be made of a polymer, coated or colored glass, ceramic, a metal (e.g., aluminum, stainless steel (STS), or magnesium), or a combination of at least two of the above materials. The first rear cover 213 may extend to at least a portion of the first lateral member 211. The first rear cover 213 may be omitted. At least a portion of the first extension member 212 may be replaced with the first rear cover 213.

The second housing 220 may include a second rear cover 223 coupled with at least a portion of the second lateral member 221. The second rear cover 223 may be disposed in a manner in which it couples with at least a portion of the second extension member 222. The second rear cover 223 may be formed integrally with the second lateral member 221. The second rear cover 223 may be made of a polymer, coated or colored glass, ceramic, a metal (e.g., aluminum, stainless steel (STS), or magnesium), or a combination of at least two of the above materials. The second rear cover 223 may extend to at least a portion of the second lateral member 221. The second rear cover 223 may be omitted. At least a portion of the second extension member 222 may be replaced with the second rear cover 223.

The rollable display 230 may include a first portion 230a (e.g., flat portion) visible from the outside and a second portion 230b (e.g., bendable portion or bending portion) extending from the first portion 230a and received in a manner at least partially bent into the first space 2101 of the first housing 210 so as to be invisible from the outside in a slide-in state. The first portion 230a may be disposed to be supported by the second housing 220, and the second portion 230b may be disposed to be at least partially supported by a support member (e.g., a support member 240 of FIG. 4). The second portion 230b of the rollable display 230 may form substantially the same plane as that of the first part 230a while being supported by the support member (e.g., a support member 240 of FIG. 4) when the second housing 220 is in a slide-out state along the first direction (direction ①) and be disposed visibly from the outside. The second portion 230b of the rollable display 230 may be received in a manner of bending into the first space 2101 of the first housing 210 when the second housing 220 is in a slide-in state along the second direction (direction ②) and be disposed invisibly from the outside. Accordingly, as the second housing 220 moves in a sliding manner along a designated direction (e.g., ±y-axis direction) from the first housing 210, the rollable display 230 may have a variable display area.

The rollable display 230 may have a variable length in the first direction (direction ①) according to a sliding movement of the second housing 220 relative to the first housing 210. For example, the rollable display 230 may have a first display area (e.g., an area corresponding to the first portion 230a) corresponding to a first length L1 in a slide-in state. The rollable display 230 may be expanded to have a second display area (e.g., an area including the first portion 230a and the second portion 230b) corresponding to a third length L3 longer than the first length L1 and larger than the first display area according to a sliding movement of the second housing 220 additionally moved by a second length L2 relative to the first housing 210 in the slide-out state.

The electronic device 200 may include at least one of an input device (e.g., a microphone 203-1), an audio output device (e.g., a call receiver 206 and/or a speaker 207), sensor modules 204 and 217, a camera module (e.g., a first camera module 205 or a second camera module 216), a connector port 208 (see FIG. 4), a socket module 218, a key input device 219, or an indicator (not illustrated) disposed in the second space 2201 of the second housing 220. The electronic device 200 may include another input device (e.g., a microphone 203) disposed in the first housing 210. The electronic device 200 may be configured such that at least one of the above-described components is omitted, or other components are additionally included. At least one of the above-described components may be disposed in the first space 2101 of the first housing 210.

The input device may include a microphone 203-1. The input device (e.g., the microphone 203-1) may include a plurality of microphones disposed to detect the direction of sound. The audio output device may include, for example, a call receiver 206 and a speaker 207. The speaker 207 may correspond to the outside through at least one speaker hole formed in the second housing 220 at a position (e.g., the fifth side surface 2212) visually exposed to the outside regardless of the slide-in/slide-out state. The call receiver 206 may include a speaker (e.g., piezo speaker) operating while a separate speaker hole is excluded.

The socket module 218 (e.g., SIM tray) may be disposed at a position visually exposed to the outside regardless of the slide-in/slide-out state. For example, the socket module 218 may be disposed at the fifth side surface 2212 of the second housing 220.

The sensor modules 204 and 217 may generate an electrical signal or a data value corresponding to an internal operation state of the electronic device 200 or an external environmental state. The sensor modules 204 and 217 may include, for example, a first sensor module 204 (e.g., proximity sensor or illuminance sensor) disposed at the front surface of the electronic device 200 and/or a second sensor module 217 (e.g., heart rate monitoring (HRM) sensor) disposed at the rear surface 200b of the electronic device 200. The first sensor module 204 may be disposed under the rollable display 230 at the front surface 200a of the electronic device 200. The first sensor module 204 and/or the second sensor module 217 may include at least one of a proximity sensor, an illuminance sensor, a time of flight (TOF) sensor, an ultrasonic sensor, a fingerprint recognition sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, or a humidity sensor.

The camera module may include a first camera module 205 disposed at the front surface of the electronic device 200 and a second camera module 216 disposed at the rear surface 200b of the electronic device 200. The electronic device 200 may include a flash (not illustrated) positioned near the second camera module 216. The camera modules 205 and 216 may include one or a plurality of lenses, an image sensor, and/or an image signal processor. The first camera module 205 may be disposed under the rollable display 230, and be configured to photograph a subject through a portion of an active area (e.g., display area) of the rollable display 230.

The first camera module 205 of the camera modules and a sensor module 204 of the sensor modules 204 and 217 may be disposed to detect an external environment through the rollable display 230. For example, in the second space 2201 of the second housing 220, the first camera module 205 or the sensor module 204 may be disposed to contact an external environment through a transmission area or a perforated opening formed in the rollable display 230. An area facing the first camera module 205 of the rollable display 230 may be a portion of an active area for displaying contents and be formed as a transmission area having a designated transmittance. The transmission area may be formed to have a transmittance in a range of about 5% to about 20%. Such a transmission area may include an area overlapped with an effective area (e.g., view angle area) of the first camera module 205, through which light for generating an image by an image sensor passes. For example, the transmission area of the rollable display 230 may include an area having a lower pixel disposition density and/or a lower wiring density than that of the periphery. For example, the transmission area may be replaced with the above-described opening. For example, the first camera module 205 may include an under display camera (UDC). The sensor module 204 may not be visually exposed through the rollable display 230 in the second space 2201 of the second housing 220 but may be disposed to perform a function thereof.

The electronic device 200 may include at least one antenna element (e.g., an antenna element 224b of FIG. 4) electrically connected to a wireless communication circuit (e.g., the wireless communication module 192 of FIG. 1) disposed in an internal space (e.g., the second space 2201 of the second housing 220). The electronic device 200 may include a bezel antenna A disposed through at least a portion of the conductive first lateral member 211 of the first housing 210. For example, the bezel antenna A may include a conductive portion 227 (e.g., conductive member) disposed through at least a portion of the second side surface 2112 and the third side surface 2113 of the first lateral member 211 and electrically separated through at least one segmented portion 2271 and 2272 made of a non-conductive material (e.g., polymer). The wireless communication circuit (e.g., the wireless communication module 192 of FIG. 1) may be configured to transmit or receive a wireless signal in at least one frequency band (e.g., about 600 MHz to 9000 MHz) (e.g., legacy band or NR band) designated through the conductive portion 227. The electronic device 200 may include a side cover 2112a disposed at the second side surface 2112 in order to cover at least a portion of the at least one segmented portion 2271. The bezel antenna A may be disposed in at least one of the first side surface 2111, the second side surface 2112, or the third side surface 2113. The bezel antenna A may be disposed in at least one of the fourth side surface 2211, the fifth side surface 2212, or the sixth side surface 2213 of the second housing 220. The electronic device 200 may further include at least one antenna module (e.g., mmWave antenna module or mmWave antenna structure) disposed in an internal space (e.g., the first space 2101 or the second space 2201) and disposed to transmit or receive a wireless signal in a frequency band ranging from about 3 GHz to 100 GHz through another wireless communication circuit (e.g., the wireless communication module 192 of FIG. 1).

The slide-in/slide-out operation of the electronic device 200 may be performed automatically. For example, the slide-in/slide-out operation of the electronic device 200 may be performed through gear coupling of a driving motor (e.g., a driving motor 260 of FIG. 4) including a pinion gear (e.g., a pinion gear 261 of FIG. 4) disposed in the first space 2101 of the first housing 210 and a rack gear (e.g., a rack gear 2221 of FIG. 4) disposed in the second space 2201 of the second housing 220 and gear-coupled with the pinion gear 261. The driving motor 260 including the pinion gear 261 may be disposed in the second space 2201 of the second housing 220, and the rack gear 2221 coupled with the pinion gear 261 may be disposed in the first space 2101 of the first housing 210. For example, in the case that the processor (e.g., the processor 120 of FIG. 1) of the electronic device 200 detects a triggering signal for changing from a slide-in state to a slide-out state or from a slide-out state to a slide-in state, the processor may operate a driving motor (e.g., a driving motor 260 of FIG. 4) disposed inside the electronic device 200. The triggering signal may include a signal according to selection (e.g., touch) of an object displayed on the rollable display 230 or a signal according to a manipulation of a physical button (e.g., key button) included in the electronic device 200. The slide-in/slide-out operation of the electronic device 200 may be performed manually through the user manipulation.

The electronic device 200 is described as having a structure in which the second housing 220 slides in and/or out relative to the first housing 210 along a longitudinal direction (e.g., vertical direction) (e.g., ± y-axis direction) thereof, but it is not limited thereto. For example, the electronic device 200 may have a structure in which the second housing 220 slides in and/or out relative to the first housing 210 along a width direction (e.g., horizontal direction) (e.g., ± x-axis direction) perpendicular to a longitudinal direction thereof. The electronic device 200 may be formed such that a length of the second side surface 2112 of the first housing 210 is longer than that of the first side surface 2111. In this case, a length of the fifth side surface 2212 of the second housing 220 may also be formed to be longer than that of the fourth side surface 2211 to correspond thereto.

FIG. 4 is an exploded perspective view illustrating an electronic device.

In describing the electronic device 200 of FIG. 4, substantially the same symbols are given to the same components as those of the electronic device 200 of FIGS. 2A to 3B, and a detailed description thereof may be omitted.

With reference to FIG. 4, the electronic device 200 may include a first housing 210 including a first space 2101, a second housing 220 slidably coupled from the first housing 210 and including a second space 2201, a support member 240 fixed to at least a portion of the second housing 220 and at least partially bendably received into the first space 2101 according to a slide-in operation, a rollable display 230 disposed to receive the support from at least a portion of the support member 240 and the second housing 220, and a drive module (e.g., drive mechanism) for driving the second housing 220 from the first housing 210 in a slide-in direction (e.g., -y-axis direction) and/or a slide-out direction (e.g., y-axis direction). The first housing 210 may include a first lateral member 211 and a first rear cover 213 coupled with at least a portion of the first lateral member 211 (e.g., at least a portion of the first extension member 212). The second housing 220 may include a second lateral member 221 and a second rear cover 223 coupled with at least a portion of the second lateral member 221 (e.g., at least a portion of the second extension member 222). The drive module may include a driving motor 260 disposed in the first space 2101 and including a pinion gear 261, and a rack gear 2221 disposed to gear-couple with the pinion gear 261 in the second space 2201. The drive module may further include a reduction module (e.g., reduction gear assembly) disposed to reduce the rotational speed and to increase the driving force by being coupled with the driving motor 260. The driving motor 260 may be disposed to be supported by the motor bracket 260a disposed in the support bracket 225 disposed in the first space 2101 of the first housing 210. The driving motor 260 may be fixed to an end portion (e.g., edge) of the support bracket 225 in a slide-out direction (e.g., y-axis direction) in the first space 2101. The rack gear 2221 may be disposed in a manner that it is fixed to the second extension member 222 of the second housing 220. The rack gear 2221 may be integrally formed by injection molding at least a portion of the second extension member 222. The rack gear 2221 may be disposed to have a length in a direction parallel to a sliding direction (e.g., ± y-axis direction). Accordingly, when the electronic device 200 is assembled, the pinion gear 261 may maintain a state of gear coupling with the rack gear 2221, and the pinion gear 261 provided with a driving force of the driving motor 260 may move along the rack gear 2221; thus, the second housing 220 may be moved relative to the first housing 210. A sliding distance of the second housing 220 may be determined by a length of the rack gear 2221.

The electronic device 200 may include a plurality of electronic components disposed in the second space 2201. The plurality of electronic components may include a first substrate 251 (e.g., main substrate), a camera module 216, a speaker 207, a connector port 208, and a microphone 203-1 disposed around the first substrate 251. The plurality of electronic components may be disposed around the first substrate 251 in the second space 2201 of the second housing 220; thus, efficient electrical connection may be possible. At least one of the plurality of electronic components may be disposed in the first space 2101 of the first housing 210.

The electronic device 200 may include a rear bracket 224 disposed between the second extension member 222 and the second rear cover 223 in the second housing 220. The rear bracket 224 may be disposed to cover at least a portion of the plurality of electronic components. The rear bracket 224 may be structurally coupled to at least a portion of the second extension member 222. The rear bracket 224 may be omitted. The rear bracket 224 may be disposed to cover the plurality of electronic components and to support the second rear cover 223. The rear bracket 224 may include an opening 224a (e.g., through hole) or a notch area 224c (e.g., cutting portion) formed in an area corresponding to the camera module 216 and/or the sensor module (e.g., the sensor module 217 of FIG. 3B). The rear bracket 224 may include at least one antenna element 224b. In an embodiment, when the rear bracket 224 is formed with an extruded product (e.g., antenna carrier) of a dielectric material, the at least one antenna element 224b may be disposed at an outer surface of the rear bracket 224. The at least one antenna element 224b may include a laser direct structuring (LDS) antenna pattern formed on an outer surface of the rear bracket 224. The at least one antenna element 224b may include a conductive plate attached to an outer surface of the rear bracket 224, and conductive paint or a conductive pattern formed on the outer surface. The at least one antenna element 224b may be disposed in a manner built into the rear bracket 224 during extrusion. The at least one antenna element 224b may be configured to transmit or receive a wireless signal in a designated frequency band (e.g., legacy band) by being electrically connected to a wireless communication circuit (e.g., the wireless communication module 192 of FIG. 1) disposed on the first substrate 251. The camera module 216 and/or the sensor module 217 may be disposed to detect an external environment through the opening 224a or the notch area 224c. In the second rear cover 223, an area corresponding to at least the camera module 216 and/or the sensor module 217 may be processed to be transparent. The second rear cover 223 may include a through hole formed in an area corresponding to at least the camera module 216 and/or the sensor module 217. In this case, the through hole may be covered by a transparent window. The camera module 216 and/or the sensor module 217 may be configured to operate in only the case that the electronic device 200 is in a slide-out state.

The connector port 208 may correspond to the outside through a connector port hole formed in the second housing 220 in a slide-out state. The connector port 208 may correspond to the outside through an opening formed in the first housing 210 in a slide-in state and formed to correspond with the connector port hole.

The electronic device 200 may include a support bracket 225 disposed in the first space 2101 of the first housing 210. The support bracket 225 may include a support portion 2252 having an outer surface formed in a curved shape so as to support a rear surface of the support member 240 disposed at one end and bent during a sliding operation changing from a slide-out state to a slide-in state. The support bracket 225 may include a support structure for supporting and fixing a driving motor 260 through the motor bracket 260a. The support bracket 225 may include a battery mounting portion 2251 for receiving a battery B. The driving motor 260 may be disposed at a farthest end portion (e.g., edge) in the slide-out direction (e.g., the y-axis direction) in the support bracket 225. For example, when the assembly of the electronic device 200 is completed, the driving motor 260 may be disposed at a position closest to the first substrate 251 among electronic components disposed in the first housing 210, thereby helping to minimize the size and/or length of a flexible substrate F1 (e.g., flexible printed circuit board (FPCB)) for electrically connecting the first substrate 251 and the driving motor 260. The electronic device 200 may include a pair of guide rails 226 disposed at both side surfaces of the support bracket 225 to guide both ends of the support member 240 in the sliding direction.

The first housing 210 may include an opening 212a (e.g., through hole) disposed in an area corresponding to the camera module 216 and/or the sensor module 217 disposed in the second housing 220 when the electronic device 200 is in a slide-in state in the first extension member 212. The camera module 216 and/or the sensor module 217 may detect an external environment through the opening 212a formed in the first housing 210 when the electronic device 200 is in a slide-in state. An area corresponding to the camera module 216 and/or the sensor module 217 of the first rear cover 213 may be processed to be transparent.

The electronic device 200 may include an antenna member 253 and a second substrate 252 (e.g., sub-substrate) disposed between the first extension member 212 and the first rear cover 213 in the first housing 210. The second substrate 252 and the antenna member 253 may be disposed in at least a portion of the first extension member 212. The second substrate 252 and the antenna member 253 may be electrically connected to the first substrate 251 through at least one electrical connection member (e.g., flexible printed circuit board (FPCB) or flexible RF cable (FRC)). The antenna member 253 may include a multi-function coil or multi-function core (MFC) antenna for performing a wireless charging function, a near field communication (NFC) function, and/or an electronic payment function. The antenna member 253 may be electrically connected to the second substrate 252, thereby being electrically connected to the first substrate 251 through the second substrate 252. The second substrate 252 and/or the antenna member 253 may be electrically connected to the first substrate 251 through at least a portion of the flexible substrate F1 that connects the driving motor 260 and the first substrate 251.

The support member 240 may be guided by the guide rail 226 during the slide-in/slide-out operation. The support member 240 may include a plurality of multi-bars 241 rotatably coupled with respect to each other and guide protrusions 2411 protruded at both ends of each of the multi-bars 241. The guide rail 226 may include a guide slit 2261 formed at a position corresponding to a movement trajectory of the support member 240. When the support member 240 fixed in a manner of being attached to the rear surface of the rollable display 230 is movably coupled with the guide rail 226, the guide protrusions 2411 move along the guide slits 2611, thereby helping to reduce the phenomenon of the rollable display 230 being detached or deformed during operation.

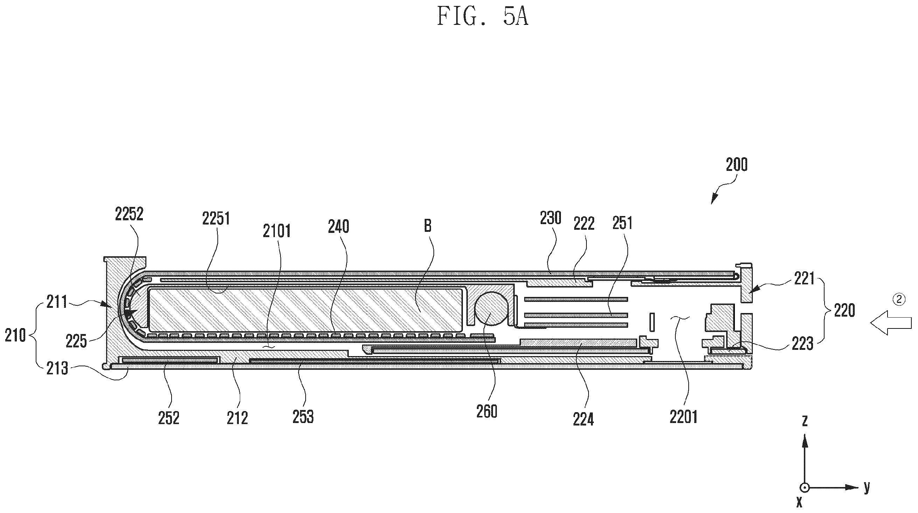

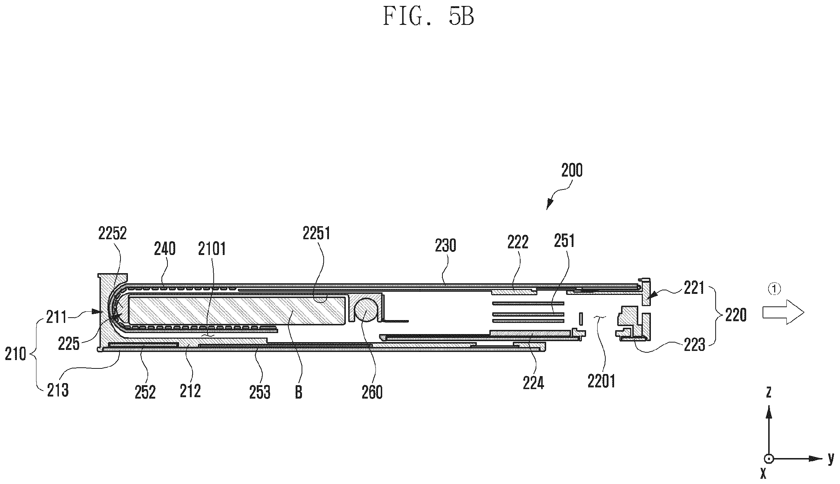

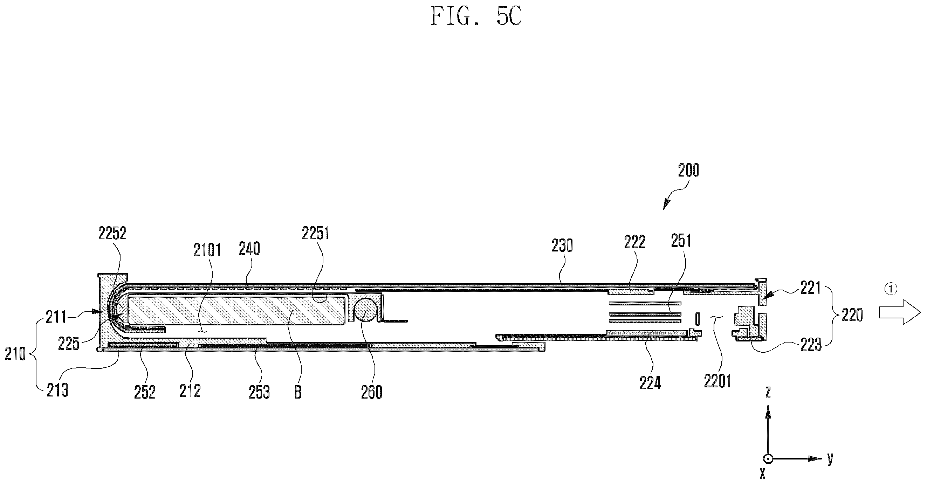

FIG. 5A is a cross-sectional view illustrating an electronic device taken along line 5a-5a of FIG. 2A. FIG. 5B is a cross-sectional view illustrating an electronic device in an intermediate state. FIG. 5C is a cross-sectional view illustrating an electronic device taken along line 5c-5c of FIG. 3A.

In describing the electronic device 200 of FIGS. 5A to 5C, substantially the same reference numerals are given to the same components as those of the electronic device 200 of FIG. 4, and a detailed description thereof may be omitted.

With reference to FIGS. 5A to 5C, an electronic device 200 may include a first housing 210 having a first space 2101, a second housing 220 having a second space 2201, a support member 240 connected to the second housing 220 and at least partially received in the first space 2101 in a slide-in state, a rollable display 230 disposed to receive the support from at least a portion of the support member 240 and at least a portion of the second housing 220, and a driving motor 260 disposed in the first space 2101 and including a pinion gear (e.g., the pinion gear 261 of FIG. 4) gear-coupled with a rack gear (e.g., the rack gear 2221 of FIG. 4) of the second space 2201. The driving motor 260 may automatically move the second housing 220 in a slide-in direction (direction ②) or a slide-out direction (direction ①) relative to the second housing 220 through gear coupling of the pinion gear (e.g., the pinion gear 261 of FIG. 4) and the rack gear (e.g., the rack gear 2221 of FIG. 4).

At least a portion of the second housing 220 may be received in the first space 2101 of the first housing 210 in the slide-in state (state of FIG. 5A) of the electronic device 200. At least a portion of the rollable display 230 may be received in a manner of being bent into the first space 2101 together with the support member 240, thereby being disposed invisibly from the outside. In this case, in the rollable display 230, a first display area (e.g., the display area corresponding to the first portion 230a of FIG. 3A) may be visually exposed to the outside.

The electronic device 200 may control the driving of the driving motor 260, thereby being changed from an intermediate state (a state of FIG. 5B) to a slide-out state (a state of FIG. 5C). The electronic device 200 may be configured to stop in a designated intermediate state between the slide-in state and the slide-out state (free stop function). The electronic device 200 may be changed to a slide-in state, an intermediate state, or a slide-out state through a user manipulation in a state where no driving force is provided to the driving motor 260.

At least a portion of the second housing 220 may be changed to a slide-out state at least partially moved outwardly from the first housing 210 along the first direction (direction ①) by driving the driving motor 260. The rollable display 230 may be supported by the support bracket 225 and moved together with the support member 240 in the slide-out state (state of FIG. 5C) of the electronic device 200; thus a portion that has slid-in to the first space 2101 may be exposed at least partially visibly to the outside. In this case, in the rollable display 230, a second display area (e.g., a display area including the first portion 230a and the second portion 230b of FIG. 3A) expanded more than the first display area may be visually exposed to the outside.

The electronic device 200 may include a battery B disposed through a battery mounting portion 2251 of the support bracket 225 fixed to the first space 2101 of the first housing 210. As the battery B is disposed in the first housing 210, a separate driving gap for avoiding interference with peripheral structures due to movement may not be required. Accordingly, as the battery B is expanded in thickness in a manner that it approaches or comes into contact with the rear surface of the support member 240 from the battery mounting portion 2251 of the support bracket 225, the battery volume relatively increases, and the battery B supports the moving support member 240, thereby reducing the sagging phenomenon of the rollable display 230 and helping to improve operational reliability.

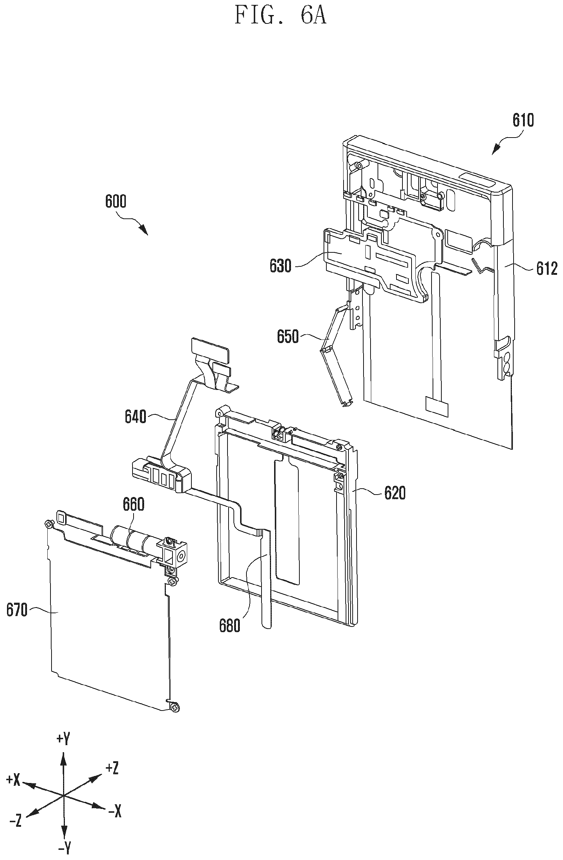

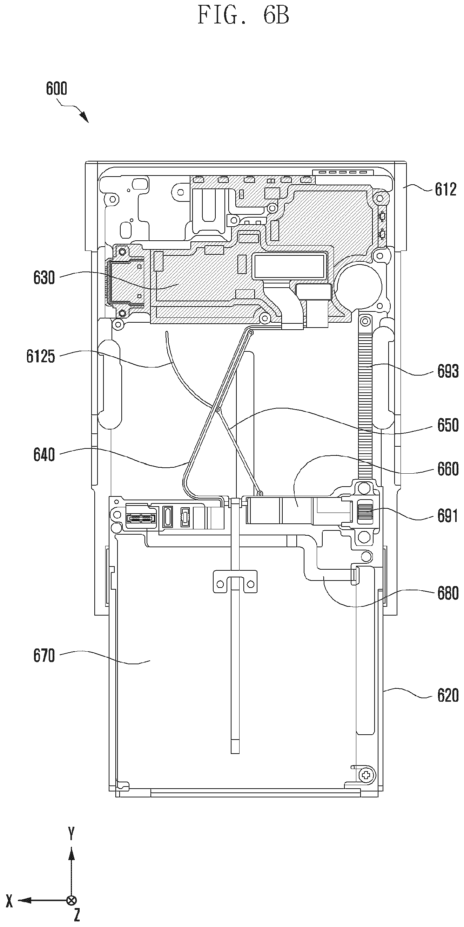

FIGS. 6A and 6B are diagrams illustrating an electronic device 600.

FIG. 6A is an exploded perspective diagram illustrating an electronic device 600. FIG. 6B is a diagram illustrating an electronic device 600 in a slide-out state.

The electronic device 600 of FIGS. 6A and 6B may mean the electronic device 101 of FIG. 1 or may include at least some of the components of the electronic device 101 illustrated in FIG. 1.

The electronic device 600 of FIGS. 6A and 6B may mean the electronic device 200 of FIG. 4 or may include at least some of the components of the electronic device 200 illustrated in FIG. 4.

In describing the electronic device 600, a width direction of the electronic device 600 may mean the X-axis direction, and a longitudinal direction of the electronic device 600 may mean the Y-axis direction. A height (or thickness) direction of the electronic device 600 may mean the Z-axis direction.

With reference to FIGS. 6A and 6B, the electronic device 600 may include a housing 610, a first support bracket 620, a first printed circuit board (e.g., the second substrate 252 of FIG. 4), a second printed circuit board 630 (e.g., the first substrate 251 of FIG. 4), a sensor structure 640, a second support bracket 650, a driving motor 660, a support member 670, a connection member 680, a pinion gear 691 (e.g., the pinion gear 261 of FIG. 4), and/or a rack gear 693 (e.g., the rack gear 2221 of FIG. 4).

The housing 610 may include a first housing (e.g., the first housing 210 of FIG. 4) and/or a second housing 612.

The housing 610 may be a component that forms an external appearance of the electronic device 600.

The second housing 612 of FIGS. 6A and 6B may mean the second housing 220 illustrated in FIG. 4 or may include at least some of the components of the second housing 220.

The second housing 612 may be movably coupled to the first housing (e.g., the first housing 210 of FIG. 4). For example, the second housing 612 may be moved along a longitudinal direction (e.g., Y-axis direction) of the electronic device 600 relative to the first housing (e.g., the first housing 210 of FIG. 4).

The electronic device 600 may include a flexible display (e.g., the rollable display 230 of FIG. 4) of which at least a portion is disposed to be supported by the housing 610.

At least some of the components of the electronic device 600 may be disposed in the second housing 612. For example, the second printed circuit board 630 may be disposed in the second housing 612.

The first support bracket 620 may be disposed in the first housing (e.g., the first housing 210 of FIG. 4).

The first printed circuit board (e.g., the second substrate 252 of FIG. 4) may be disposed in the first housing (e.g., the first housing 210 of FIG. 4).

The first support bracket 620 of FIGS. 6A and 6B may mean the support bracket 225 illustrated in FIG. 4 or may include at least some of the components of the support bracket 225.

The battery (e.g., the battery B of FIG. 4) may be disposed in the first support bracket 620.

The second printed circuit board 630 may be disposed in the second housing 612.

The driving motor 660 may mean the driving motor 260 illustrated in FIG. 4 or may include at least a portion of the driving motor 260.

The driving motor 660 may be disposed in the first housing (e.g., the first housing 210 of FIG. 4) or the second housing 612. For example, the driving motor 660 may be disposed in the first support bracket 620 disposed inside the first housing (e.g., the first housing 210 of FIG. 4). The driving motor 660 may be disposed in at least a portion of the second housing 612.

The driving motor 660 may generate a rotational force. The rotational force generated by the driving motor 660 may be transferred to the pinion gear 691. The pinion gear 691 may rotate according to the rotation of the driving motor 660.

The pinion gear 691 may be disposed to engage with the rack gear 693. According to a rotational motion of the pinion gear 691, the rack gear 693 may move linearly in a longitudinal direction (e.g., the Y-axis direction) of the electronic device 600.

The support member 670 may be disposed to cover at least a portion of the first support bracket 620.

The sensor structure 640 may be connected to the first support bracket 620 at one end and be connected the second printed circuit board 630 at the other end, which is the opposite end of the one end.

The second support bracket 650 may serve to support the sensor structure 640. The second support bracket 650 may be configured to move according to the movement of the second housing 612 with respect to the first housing (e.g., the first housing 210 of FIG. 4).

The second housing 612 may include a groove 6125 that guides the movement of the second support bracket 650.

The connection member 680 may electrically connect the sensor structure 640 to other components (e.g., the battery B of FIG. 4) of the electronic device 600.

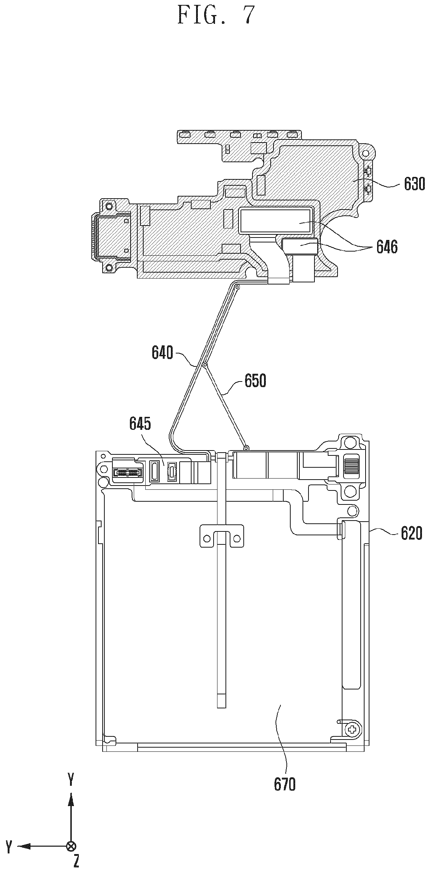

FIG. 7 is a diagram illustrating the first support bracket 620, the second printed circuit board 630, the sensor structure 640, and the second support bracket 650.

The sensor structure 640 may be connected to the first support bracket 620 at one end and be connected to the second printed circuit board 630 at the other end.

The sensor structure 640 may include a first connector 645 and/or a second connector 646. The first connector 645 may be disposed in the first support bracket 620, and the second connector 646 may be disposed on the second printed circuit board 630. The sensor structure 640 may be electrically connected to the second printed circuit board 630 using the second connector 646.

The sensor structure 640 may extend between the first support bracket 620 and the second printed circuit board 630.

The sensor structure 640 may be bendable between the first support bracket 620 and the second printed circuit board 630. For example, at least a portion of the sensor structure 640 may be bent according to a change in distance between the first support bracket 620 and the second printed circuit board 630.

The second support bracket 650 may be disposed to support at least a portion of the sensor structure 640. For example, the second support bracket 650 may be disposed to face at least a portion of the sensor structure 640 to support the sensor structure 640.

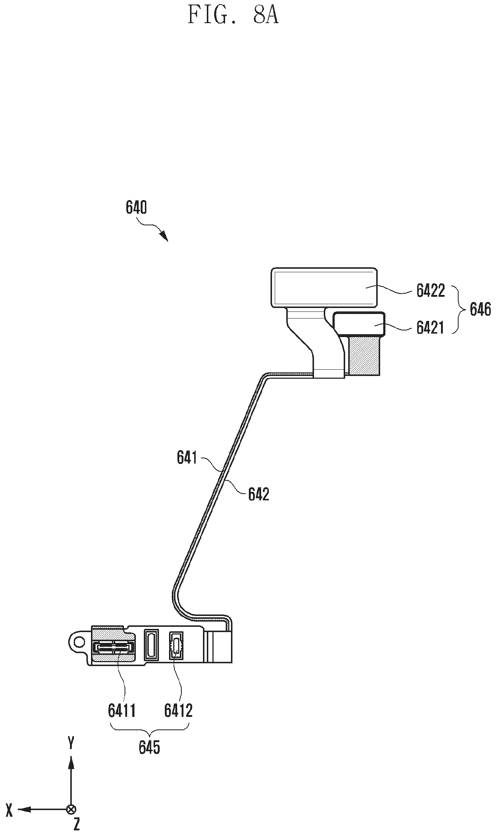

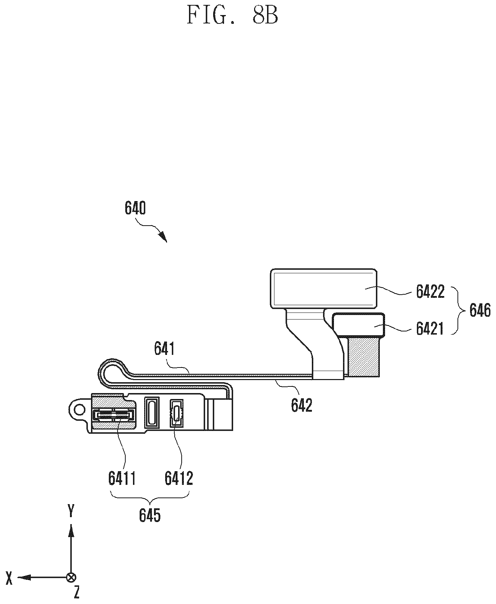

FIGS. 8A and 8B are diagrams illustrating the sensor structure 640.

FIG. 8A is a diagram illustrating the sensor structure 640 in a slide-out state of an electronic device 600. FIG. 8B is a diagram illustrating the sensor structure 640 in a state in which the first connector 645 and the second connector 646 are positioned relatively close compared to the state of FIG. 8A.

The sensor structure 640 may include a bending sensor element 641 and a flexible printed circuit board 642.

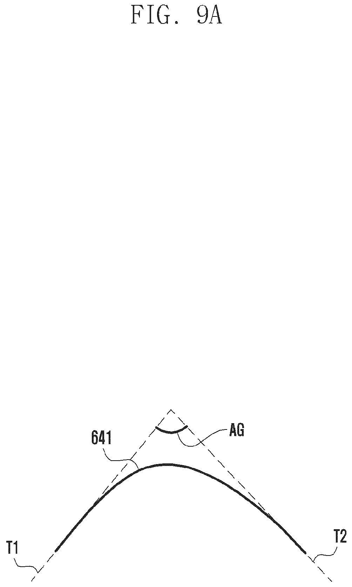

The bending sensor element 641 may measure an angle AG (see FIG. 9A) thereof, for example an angle at which the bending sensor element 641 is bent, also referred to as a degree of bending, or angular displacement of the sensor.

The bending sensor element 641 may measure a tensile strain and compressive strain thereof. The bending sensor element 641 may measure a displacement thereof.

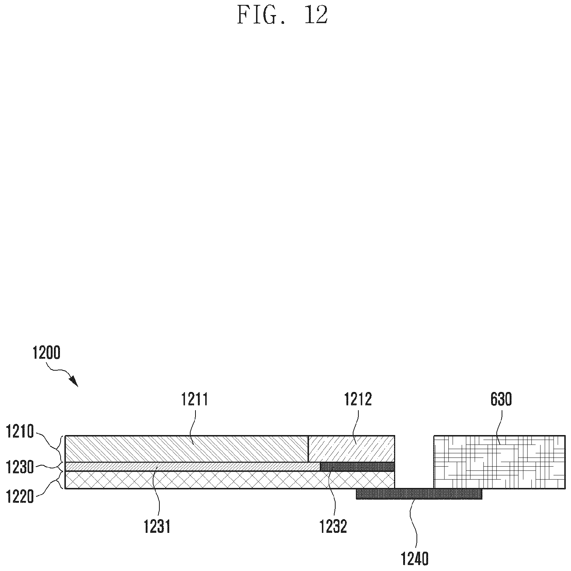

The bending sensor element 641 may be disposed on the flexible printed circuit board 642. For example, the bending sensor element 641 may be coupled to one surface of the flexible printed circuit board 642 using an adhesive member (e.g., an adhesive member 1231 of FIG. 12).

The bending sensor element 641 and the flexible printed circuit board 642 may each include a bendable material. Because the bending sensor element 641 and the flexible printed circuit board 642 include bendable materials, the sensor structure 640 may be bent in at least a portion.

The bending sensor element 641 may include a first sensor connector 6411 and/or a second sensor connector 6412. The first sensor connector 6411 may be formed at one end of the bending sensor element 641, and the second sensor connector 6412 may be formed at the other end of the bending sensor element 641.

The flexible printed circuit board 642 may include a first substrate connector 6421 and/or a second substrate connector 6422. The first substrate connector 6421 may be formed at one end of the flexible printed circuit board 642, and the second substrate connector 6422 may be formed at the other end of the flexible printed circuit board 642.

The flexible printed circuit board 642 may electrically connect the first printed circuit board (e.g., the second substrate 252 of FIG. 4) and the second printed circuit board (e.g., the first substrate 251 of FIG. 4, the second printed circuit board 630 of FIG. 7).

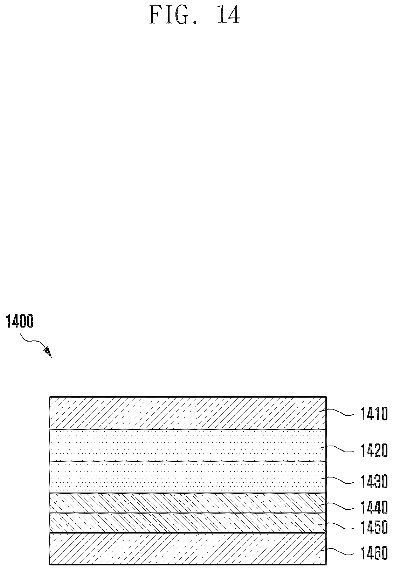

The flexible printed circuit board 642 may serve to transfer power and signals (e.g., data). The flexible printed circuit board 642 may include a transfer layer (e.g., transfer layers 1440 and 1450 of FIG. 14) in which power and signals (e.g., data) are transferred. The flexible printed circuit board 642 may include both a power transfer layer and a signal transfer layer.

FIGS. 8A and 8B illustrate that the sensor structure 640 includes one flexible printed circuit board 642, but this is an example, and the sensor structure 640 may include two or more flexible printed circuit boards 642. For example, the sensor structure 640 may include two flexible printed circuit boards 642, one of the two flexible printed circuit boards 642 may include a layer that transfers power, and the remaining one flexible printed circuit board 642 may include a layer that transfers signals (e.g., data).

The first connector 645 may include a first sensor connector 6411 and a first substrate connector 6421.

The second connector 646 may include a second sensor connector 6412 and a second substrate connector 6422.

The distance between the first connector 645 and the second connector 646 may vary according to the movement of the second housing 612 (see FIG. 6A) with respect to the first housing 210 (see FIG. 4). For example, in the case that the second housing 612 (see FIG. 6A) moves away from the first housing 210 (see FIG. 4), the distance between the first support bracket 620 (see FIG. 7) and the second printed circuit board 630 (see FIG. 7) increases, and the distance between the first connector 645 and the second connector 646 may also increase.

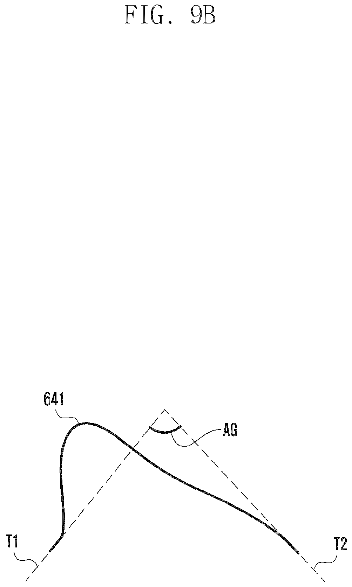

FIGS. 9A and 9B are conceptual diagrams illustrating an angle AG of a bending sensor element 641.

The bending sensor element 641 may measure an angle AG at which the bending sensor element is bent. The bending sensor element 641 may include a bending sensor (e.g., a bending sensor 1211 of FIG. 12) capable of measuring the angle AG. The angle AG of the bending sensor element 641 may mean the angle of the sensor structure 640 (see FIGS. 8A and 8B), for example the angle which the two relatively straight arms of the bending sensor element make relative to one another when the bending sensor element 641 is bent, as shown for example in FIG. 9A.

With reference to FIGS. 9A and 9B, the angle AG of the bending sensor element 641 may be an angle formed by an imaginary first straight line T1 parallel to one end portion of the bending sensor element 641 and an imaginary second straight line T2 parallel to the other end portion of the bending sensor element 641.

The angle AG of the bending sensor element 641 may be formed regardless of the shape thereof. Because the angle AG of the bending sensor element 641 means an angle formed by the first straight line T1 and the second straight line T2, it may be unrelated to the shape of the bending sensor element 641. For example, the bending shape of the bending sensor element 641 of FIG. 9A is different from the bending shape of the bending sensor element 641 of FIG. 9B, but in FIGS. 9A and 9B, angles formed by the first straight line T1 and the second straight line T2 are substantially the same; thus, the angle AG of the bending sensor element 641 illustrated in FIG. 9A may be substantially the same as the angle AG of the bending sensor element 641 illustrated in FIG. 9B. In other words, the angular displacement of the sensor is independent of the sensor path.

The bending sensor element 641 may include at least two capacitors.

A sensor (e.g., a bending sensor 1211 of FIG. 12) of the bending sensor element 641 may operate by measuring differential capacitance of the two capacitors.

When the differential capacitance is greater than or equal to a predetermined reference value, the bending sensor element 641 may recognize that tensile deformation has occurred and calculate an angle AG thereof. The angle AG of the bending sensor element 641 may be calculated based on the differential capacitance. For example, the angle AG of the bending sensor element 641 may have a linear relationship with the differential capacitance.

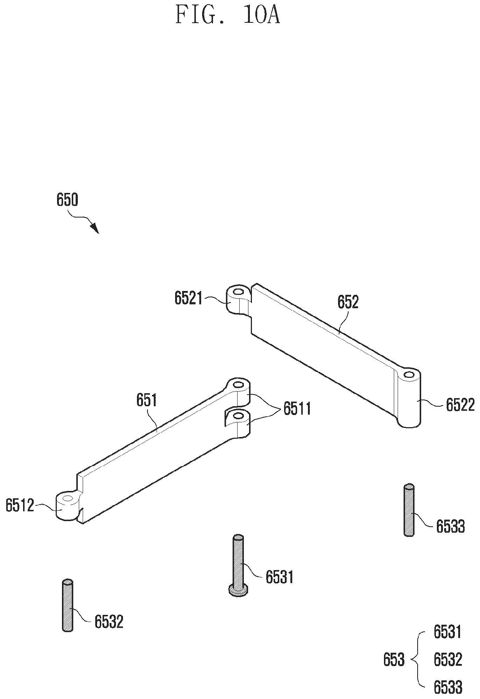

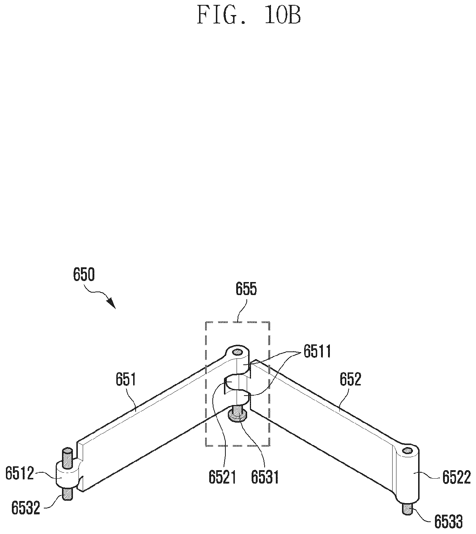

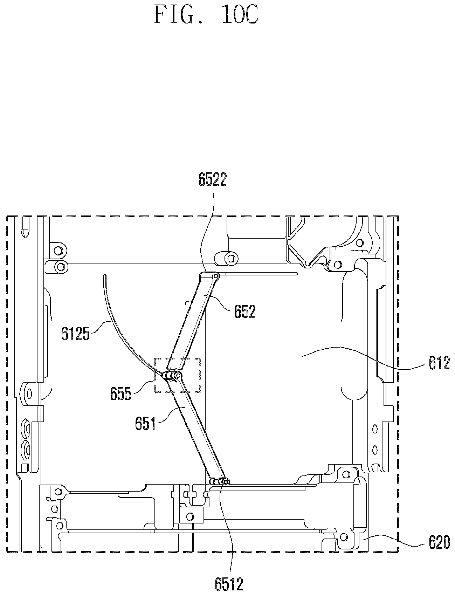

FIGS. 10A, 10B, and 10C are diagrams illustrating a second support bracket 650.

FIG. 10A is an exploded perspective view illustrating a second support bracket 650. FIG. 10B is a perspective view illustrating a second support bracket 650. FIG. 10C is a diagram illustrating a second housing 612 and a second support bracket 650.

With reference to FIG. 10A, the second support bracket 650 may include a first part 651, a second part 652, and/or a coupling pin 653.

The first part 651 may include a first coupling portion 6511 and/or a second coupling portion 6512.

The second part 652 may include a third coupling portion 6521 and/or a fourth coupling portion 6522.

The coupling pin 653 may include a first pin 6531, a second pin 6532, and/or a third pin 6533.

With reference to FIGS. 10A and 10B, the first coupling portion 6511 of the first part 651 and the third coupling portion 6521 of the second part 652 may be disposed at corresponding positions. The first coupling portion 6511 of the first part 651 and the third coupling portion 6521 of the second part 652 may be coupled using the first pin 6531.

The first part 651 and the second part 652 may be rotatably coupled to each other. For example, the first coupling portion 6511 of the first part 651 and the third coupling portion 6521 of the second part 652 may be coupled using the first pin 6531, and the first part 651 and the second part 652 may be rotated with respect to each other.

With reference to FIG. 10C, the second housing 612 according to an embodiment may include a groove 6125. The groove 6125 may include a curved shape.

With reference to FIG. 10C, the second support bracket 650 may be disposed in the second housing 612.

With reference to FIG. 10C, the second support bracket 650 may be connected to the first bracket 620 at one end and be connected to the second housing 612 at the other end. For example, the second coupling portion 6512 of the first part 651 may be coupled to the first support bracket 620. A fourth coupling portion 6522 of the second part 652 may be coupled to the second housing 612.

The second pin 6532 may be a pin for coupling an end portion of the first part 651 to the first support bracket 620. The second pin 6532 may couple the second coupling portion 6512 of the first part 651 to the first support bracket 620.

The third pin 6533 may be a pin for coupling an end portion of the second part 652 to the second housing 612. The third pin 6533 may couple the fourth coupling portion 6522 of the second part 652 to the second housing 612.

With reference to FIGS. 10B and 10C, the first coupling portion 6511, the third coupling portion 6521, and the first pin 6531 may form a hinge 655 of the second support bracket 650. For example, the hinge 655 of the second support bracket 650 may include a first coupling portion 6511, a third coupling portion 6521, and a first pin 6531, and be a portion that rotatably connects the first part 651 and the second part 652.

The groove 6125 may serve to guide movement of the second support bracket 650. For example, a hinge 655 of the second support bracket 650 may be moved along the direction in which the groove 6125 extends.

As the second housing 612 slides, the hinge 655 of the second support bracket 650 may move along the groove 6125. As the hinge 655 of the second support bracket 650 moves along the groove 6125, the angle between the first part 651 and the second part 652 may be changed within a predetermined range. Because the angle between the first part 651 and the second part 652 of the second support bracket 650 changes within a predetermined range, an angle AG (see FIG. 9A) of the sensor structure 640 (see FIG. 8A) supported by the second support bracket 650 may also be changed within a predetermined range.

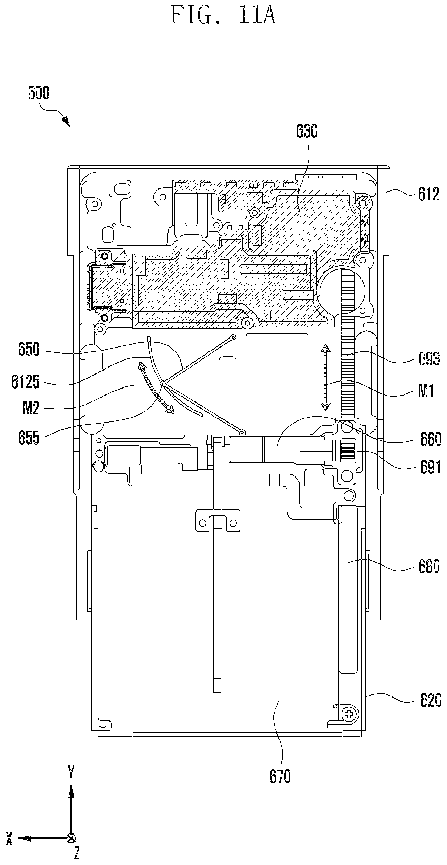

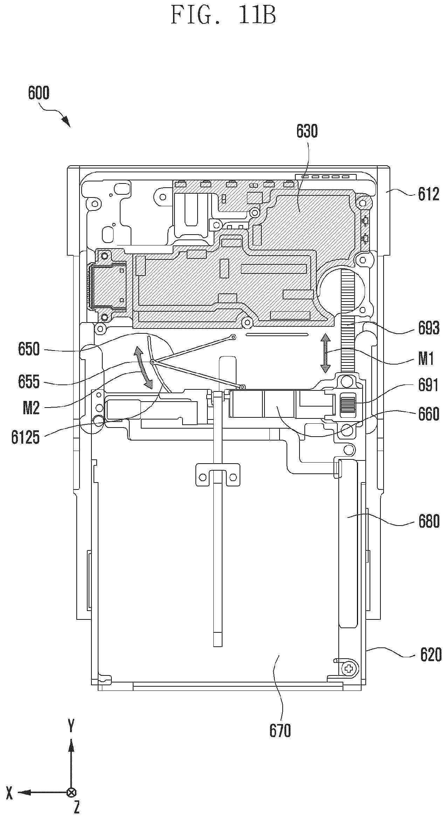

FIGS. 11A and 11B are diagrams illustrating a movement of a second support bracket 650.

FIG. 11A is a diagram illustrating a position of the second support bracket 650 in a first state of an electronic device 600. FIG. 11B is a diagram illustrating a position of the second support bracket 650 in a second state of the electronic device 600.

The first state of the electronic device 600 may mean a state in which the first support bracket 620 is moved toward the second printed circuit board 630 compared to a slide-out state (e.g., the state illustrated in FIG. 6B).

In describing the components illustrated in FIGS. 11A and 11B, a description of substantially the same components to those of FIGS. 6A and 6B may be omitted.

The second state of the electronic device 600 may mean a state in which the first support bracket 620 is moved toward the printed circuit board 630 compared to the first state of the electronic device 600.

With reference to FIGS. 11A and 11B, when the first support bracket 620 moves in a first movement direction M1, a hinge 655 of the second support bracket 650 may be moved in a second movement direction M2 along a direction in which the groove 6125 extends.

The second support bracket 650 may support the sensor structure 640 (see FIG. 8A). The second support bracket 650 may move along the groove 6125 and enable the sensor structure 640 (see FIG. 8A) to move within a predetermined angular range.

FIG. 12 is a diagram illustrating a second printed circuit board 630 and a sensor structure 1200.

The sensor structure 1200 of FIG. 12 may mean the sensor structure 640 illustrated in FIG. 8A or may include at least some of the components of the sensor structure 640 illustrated in FIG. 8A.

The sensor structure 1200 may include a bending sensor element 1210, a flexible printed circuit board 1220, a bonding portion 1230, and/or a connector 1240.

The bending sensor element 1210 may measure an angle AG (see FIG. 9A) thereof.

The bending sensor element 1210 may measure a tensile strain and compressive strain thereof. The bending sensor element 1210 may measure a displacement thereof.

The bending sensor element 1210 may include a silicone material.

The bending sensor element 1210 may include a conductive material. For example, the bending sensor element 1210 may include a conductive silicone material.

The bending sensor element 1210 may include a bending sensor 1211 and/or a sensor circuit 1212.

The bonding portion 1230 may include an adhesive member 1231 and/or a contact pad 1232.

The adhesive member 1231 may serve to couple the bending sensor element 1210 and the flexible printed circuit board 1220 to each other.

The adhesive member 1231 may include an adhesive material. For example, the adhesive member 1231 according to an embodiment may include an anisotropic conductive paste (ACP). The adhesive member 1231 may include an epoxy adhesive in the form of a polymer liquid.

The contact pad 1232 may serve to electrically connect the bending sensor element 1210 (e.g., the sensor circuit 1212) and the flexible printed circuit board 1220.

The flexible printed circuit board 1220 may be electrically connected to the second printed circuit board 630. The flexible printed circuit board 1220 may serve to transfer power and signals (e.g., data).

The flexible printed circuit board 1220 may electrically connect the first printed circuit board (e.g., the second substrate 252 of FIG. 4) and the second printed circuit board 630 (e.g., the first substrate 251 of FIG. 4).

The connector 1240 of FIG. 12 may include a second connector 646 illustrated in FIG. 8A.

The sensor structure 1200 may be electrically connected to the second printed circuit board 630 through the connector 1240.

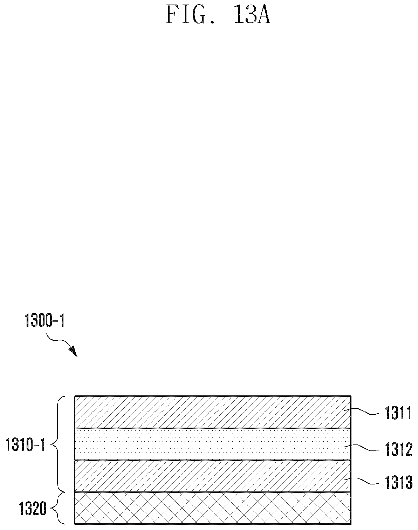

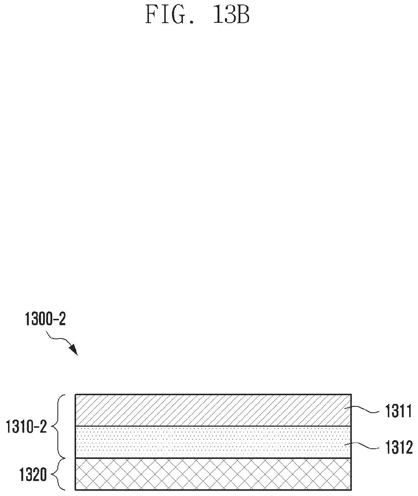

FIGS. 13A and 13B are diagrams illustrating sensor structures 1300-1 and 1300-2.

FIG. 13A is a diagram illustrating a sensor structure 1300-1 including a first protective layer 1311 and a second protective layer 1313. FIG. 13B is a diagram illustrating a sensor structure 1300-2 including a first protective layer 1311.

The sensor structures 1300-1 and 1300-2 illustrated in FIGS. 13A and 13B may mean the sensor structure 640 of FIG. 8A or may include at least some of the components of the sensor structure 640 of FIG. 8A.

The sensor structures 1300-1 and 1300-2 illustrated in FIG. 13A and 13B may mean the sensor structure 1200 of FIG. 12 or may include at least some of the components of the sensor structure 1200 of FIG. 12.

With reference to FIG. 13A, a sensor structure 1300-1 may include a bending sensor element 1310-1 and/or a flexible printed circuit board 1320.

The bending sensor element 1310-1 may include a first protective layer 1311, a dielectric layer 1312, and/or a second protective layer 1313.

The sensor structure 1300-1 may be stacked in order of the flexible printed circuit board 1320, the second protective layer 1313, the dielectric layer 1312, and the first protective layer 1311

The protective layers 1311 and 1313 and the dielectric layer 1312 may include a silicone material.

The protective layers 1311 and 1313 may serve to protect the dielectric layer 1312.

The protective layers 1311 and 1313 may include a conductive material. For example, the protective layers 1311 and 1313 may include a conductive silicone material.

The dielectric layer 1312 may include a capacitor having a predetermined capacitance. The dielectric layer 1312 may include at least two capacitors.

The flexible printed circuit board 1320 may include a conductive material.

With reference to FIG. 13B, a sensor structure 1300-2 according to an embodiment may include a bending sensor element 1310-2 and/or a flexible printed circuit board 1320.

The sensor structure 1300-2 may be stacked in order of the flexible printed circuit board 1320, the dielectric layer 1312, and the first protective layer 1311.

The implementation described with reference to FIG. 13B does not include a second protective layer 1313 included in the implementation described with reference to FIG. 13A. For example, in the implementation described with reference to FIG. 13B, a flexible printed circuit board 1320 including a conductive material may function as the second protective layer 1313 of FIG. 13A.

The bending sensor elements 1310-1 and 1310-2 may measure an angle AG (see FIG. 9A) thereof. For example, an angle of the bending sensor elements 1310-1 and 1310-2 may be calculated using differential capacitance of two capacitors included in the dielectric layer 1312.

The bending sensor elements 1310-1 and 1310-2 may measure a tensile strain and compressive strain thereof. The bending sensor elements 1310-1 and 1310-2 may measure a displacement thereof.

FIG. 14 is a diagram illustrating a sensor structure 1400.

The sensor structure 1400 may be produced by integrally forming a bending sensor element (e.g., the bending sensor element 641 of FIG. 8A) and a flexible printed circuit board (e.g., the flexible printed circuit board 642 of FIG. 8A).

The sensor structure 1400 illustrated in FIG. 14 may mean the sensor structure 640 of FIG. 8A or may include at least some of the components of the sensor structure 640 of FIG. 8A.

The sensor structure 1400 may include a first protective layer 1410, a first dielectric layer 1420, a second dielectric layer 1430, a first transfer layer 1440, a second transfer layer 1450, and/or a second protective layer 1460.

The protective layers 1410 and 1460 and the dielectric layers 1420 and 1430 may include a silicone material.

The protective layers 1410 and 1460 may serve to protect the dielectric layers 1420 and 1430.

The protective layers 1410 and 1460 may include a conductive material. For example, the protective layers 1410 and 1460 may include a conductive silicone material.

The second protective layer 1460 may include a ground of the flexible printed circuit board 642 (see FIG. 8A). For example, the second protective layer 1460 may be a layer formed with a ground of the flexible printed circuit board 642 (see FIG. 8A). The second protective layer 1460 may have a form in which a conductive silicone material for protecting the dielectric layers 1420 and 1430 and the transfer layers 1440 and 1450 are added to the ground of the flexible printed circuit board 642 (see FIG. 8A).

The transfer layers 1440 and 1450 may be a layer included in the flexible printed circuit board 642 (see FIG. 8A).

Power and/or signals may be transferred through the transfer layers 1440 and 1450. The first transfer layer 1440 and the second transfer layer 1450 may be a layer in which power and/or signals (e.g., data) are/is transferred.

The sensor structure 1400 may be constituted in a form in which the transfer layers 1440 and 1450 of the flexible printed circuit board 642 (see FIG. 8A) are disposed between the first protective layer 1410 and the second protective layer 1460 of the bending sensor element (e.g., the bending sensor element 641 of FIG. 8A).

When the bending sensor element (e.g., the bending sensor element 641 of FIG. 8A) and the flexible printed circuit board (e.g., the flexible printed circuit board 642 of FIG. 8A) are formed integrally, the number of total layers of the sensor structure 1400 may be reduced. As the sensor structure 1400 integrally forms the bending sensor element and the flexible printed circuit board, the number of total layers of the sensor structure 1400 is reduced; thus, a production cost required for producing the sensor structure 1400 may be reduced.

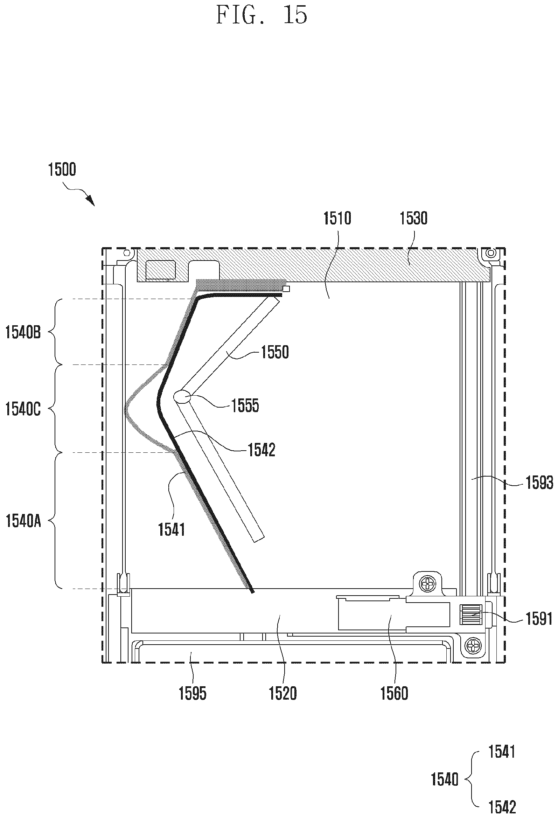

FIG. 15 is a diagram illustrating an electronic device 1500.

The electronic device 1500 of FIG. 15 may mean the electronic device 600 of FIGS. 6A and 6B or may include at least some of the components of the electronic device 600 illustrated in FIGS. 6A and 6B.

With reference to FIG. 15, an electronic device 1500 may include a housing 1510, a first support bracket 1520, a printed circuit board 1530, a sensor structure 1540, a second support bracket 1550, a driving motor 1560, a pinion gear 1591, a rack gear 1593, and/or a battery 1595.

In describing the components illustrated in FIG. 15, a description of substantially the same components to those of FIGS. 6A and 6B may be omitted.

The sensor structure 1540 may include a bending sensor element 1541 and/or a flexible printed circuit board 1542.

The flexible printed circuit board 1542 may transfer power of the battery 1595 to the printed circuit board 1530.

The sensor structure 1540 may be supported by the second support bracket 1550.

The second support bracket 1550 may include a hinge 1555 in at least a portion thereof. At least a portion of the second support bracket 1550 may rotate about the hinge 1555.

The sensor structure 1540 may include straight areas 1540A and 1540B and/or a bending area 1540C.

The straight areas 1540A and 1540B may be an area in which the sensor structure 1540 is extended in a straight line. The straight areas 1540A and 1540B may include a first straight area 1540A and/or a second straight area 1540B.

The bending area 1540C may be an area in which the sensor structure 1540 is bent and extended in at least a portion thereof. The bending area 1540C may be positioned between the first straight area 1540A and the second straight area 1540B.

In the straight areas 1540A and 1540B of the sensor structure 1540, the bending sensor element 1541 and the flexible printed circuit board 1542 may be coupled to each other.

In the bending area 1540C of the sensor structure 1540, the bending sensor element 1541 and the flexible printed circuit board 1542 may be spaced apart from each other. For example, in the bending area 1540C, the bending sensor element 1541 and the flexible printed circuit board 1542 may be positioned at a distance from each other without being coupled to each other.

The displacement and stress of the bending sensor element 1541 and the displacement and stress of the flexible printed circuit board 1542 with respect to an external force may be different from each other. For example, even if the same external force is applied to the bending sensor element 1541 and the flexible printed circuit board 1542, the displacement and stress of the bending sensor element 1541 and the displacement and stress of the flexible printed circuit board 1542 may be different from each other. As an external force applied to the bending sensor element 1541 and the flexible printed circuit board 1542 increases, the difference between the displacement and stress of the bending sensor element 1541 and the displacement and stress of the flexible printed circuit board 1542 may increase.

Among areas of the flexible printed circuit board 1542, an area positioned in the bending area 1540C of the sensor structure 1540 may be subjected to a greater stress than that of other areas. Therefore, in the bending area 1540C of the sensor structure 1540, when the flexible printed circuit board 1542 and the bending sensor element 1541 are coupled, the bending sensor element 1541 may be subjected to a relatively large stress.

The electronic device 1500 may dispose the bending sensor element 1541 and the flexible printed circuit board 1542 to be spaced apart from each other in the bending area 1540C of the sensor structure 1540 to reduce a stress applied to the bending sensor element 1541.

In the electronic device 1500, in the bending area 1540C, because the stress applied to the bending sensor element 1541 is reduced, breakage of the bending sensor element 1541 may be prevented or reduced.

In the electronic device 1500, in the bending area 1540C, because the stress applied to the bending sensor element 1541 is reduced, the bending sensor element 1541 may easily measure an accurate angle AG (e.g., see FIG. 9A).

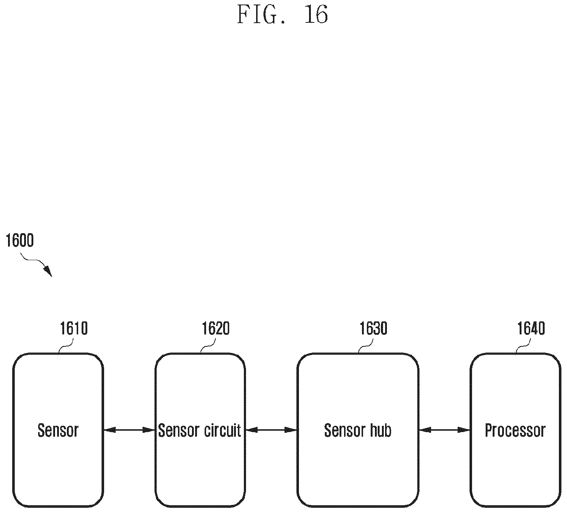

FIG. 16 is a block diagram illustrating an electronic device 1600.

The electronic device 1600 of FIG. 16 may mean the electronic device 600 of FIGS. 6A and 6B or may include at least some of the components of the electronic device 600 illustrated in FIGS. 6A and 6B.

FIG. 16 is a block diagram illustrating components related to angle AG (e.g., see FIG. 9A) measurement and distance (e.g., a distance in which the second housing is moved) calculation among components of an electronic device 1600 according to an embodiment.

Arrows illustrated in FIG. 16 may indicate that each component is electrically connected. For example, a sensor 1610 may be electrically connected to a sensor circuit 1620, and the sensor circuit 1620 may be electrically connected to a sensor hub 1630. The sensor hub 1630 may be electrically connected to a processor 1640.

With reference to FIG. 16, the electronic device 1600 may include a sensor 1610, a sensor circuit 1620, a sensor hub 1630, and/or a processor 1640.

The sensor 1610 may include a bending sensor 1211 (see FIG. 12). The sensor 1610 may measure an angle AG (see FIG. 9A) of the bending sensor element 641 (see FIG. 9A).

The sensor circuit 1620 may transfer angle information including an angle AG (see FIG. 9A) measured by the sensor 1610 to the sensor hub 1630.

The sensor hub 1630 may be disposed on the second printed circuit board 630 (see FIG. 6A). The sensor hub 1630 may be a component included in the second printed circuit board 630 (see FIG. 6A).

The processor 1640 may mean the processor 120 of FIG. 1 or may include the processor 120 of FIG. 1.

The processor 1640 may control other components (e.g., hardware or software components) of the electronic device 1600 and perform various data processing or calculations.

The processor 1640 may include an application processor.

The processor 1640 may be disposed on the second printed circuit board 630 (see FIG. 6A).

The processor 1640 may be configured to calculate a distance moved by the second housing 612 (see FIG. 6A) based on angle information received by the sensor hub 1630. For example, the processor 1640 may convert angle information received by the sensor hub 1630 into a distance moved by the second housing 612 (see FIG. 6A) using predetermined algorithm.

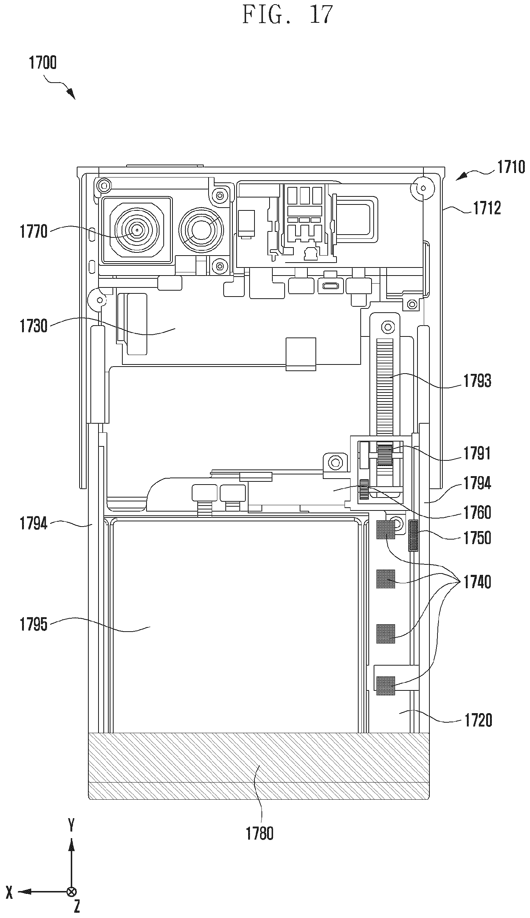

FIG. 17 is a diagram illustrating an electronic device 1700 according to a comparative example.

With reference to FIG. 17, an electronic device 1700 according to a comparative example may include a housing 1710, a support bracket 1720, a printed circuit board 1730, a magnetic body detection sensor 1740, a magnetic body 1750, a driving motor 1760, a camera module 1770, a display 1780, a pinion gear 1791 and rack gear 1793, a rack gear guide 1794, and a battery 1795.

The housing 1710 may include a first housing (not illustrated) and/or a second housing 1712. The first housing (not illustrated) and the second housing 1712 may be movably coupled to each other.

The magnetic body detection sensor 1740 may be disposed in the second housing 1712. The magnetic body detection sensor 1740 may include a hall sensor.

The magnetic body 1750 may be disposed in the support bracket 1720.

The electronic device 1700 may include a plurality of magnetic body detection sensors 1740. The plurality of magnetic body detection sensors 1740 may be disposed spaced apart from each other.

The electronic device 1700 may detect a position of the magnetic body 1750 and a relative movement of the magnetic body 1750 through the magnetic body detection sensor 1740. For example, when the support bracket 1720 is moved in one direction (e.g., Y-axis direction) with respect to the second housing 1712, the magnetic body 1750 disposed in the support bracket 1720 may be moved in one direction (e.g., Y-axis direction) with respect to the second housing 1712. The plurality of magnetic body detection sensors 1740 may each detect a relative movement of the magnetic body 1750.

The electronic device 1700 may measure a distance between each of the plurality of magnetic body detection sensors 1740 and the magnetic body 1750 and calculate a distance in which the second housing 1712 is slide-moved with respect to the first housing (not illustrated) based on the distance.

The electronic device 1700 may require a separate component (e.g., a substrate for disposing the magnetic body detection sensor, a signal line for driving the magnetic body detection sensor) for the magnetic body detection sensor 1740. The electronic device 1700 according to the comparative embodiment may require a space for disposing the magnetic body detection sensor 1740 and components for the magnetic body detection sensor 1740.

In the electronic device 1700, because the plurality of magnetic body detection sensors 1740 are disposed at intervals, it may be relatively difficult to measure an accurate position of the magnetic body 1750. For example, in the electronic device 1700, because the plurality of magnetic body detection sensors 1740 are disposed at intervals, it may be difficult to continuously measure positions of the magnetic body 1750 and the support bracket 1720 in which the magnetic body 1750 is disposed.

Because the electronic device 1700 includes a magnetic body 1750 for measuring a moving distance of the second housing 1712, the electronic device 1700 may affect a magnetic body outside the same or may be affected by an external magnetic body thereof.

An electronic device 600 according to an embodiment may include a first housing 210, a second housing 612, a first support bracket 620, a first printed circuit board 252, a second printed circuit board 630, a sensor structure 640, and a second support bracket 650.

The second housing 612 may be movably coupled to the first housing 210.

The first support bracket 620 may be disposed in the first housing 210.

The first printed circuit board 252 may be disposed in the first housing 210.

The second printed circuit board 630 may be disposed in the second housing 612.

The sensor structure 640 may be connected to the first support bracket 620 at one end and be connected to the printed circuit board 630 at the other end.

The second support bracket 650 may support the sensor structure 640.

The sensor structure 640 may include a bending sensor element 641 and a flexible printed circuit board 642.

The bending sensor element 641 may include a dielectric layer 1312 and protective layers 1311 and 1313 protecting the dielectric layer 1312.

The bending sensor element 641 may measure an angle AG of the sensor structure 640.

The flexible printed circuit board 642 may electrically connect the first printed circuit board 252 and the second printed circuit board 630.

The flexible printed circuit board 642 may have at least a portion coupled to the bending sensor element 641.

The electronic device 600 may include processors 120 and 1640 disposed in the second printed circuit board 630.

The processors 120 and 1640 may be configured to calculate a distance in which the second housing 612 has moved in a longitudinal direction of the electronic device 600 with respect to the first housing 210 based on an angle of the sensor structure 640 measured by the bending sensor element 641.

The electronic device 600 may accurately measure a distance in which the second housing 612 is moved with respect to the first housing 210 compared to the electronic device 1700 according to the comparative embodiment. For example, the electronic device 600 may calculate continuously a moving distance of the second housing 612 based on a continuously changing angle AG of the bending sensor element 641.

The electronic device 600 may perform accurate control thereof based on the continuously calculated movement distance of the second housing 612.

The electronic device 600 may control more accurately the flexible display 230 based on the continuously calculated movement distance of the second housing 612. For example, the electronic device 600 may control to expand or reduce more accurately a display area of the flexible display 230.

The electronic device 600 may be configured to perform various operations based on the continuously calculated movement distance of the second housing 612. The electronic device 600 may be configured to accurately calculate a slide-in speed and/or slide-out speed of the second housing 612 based on the continuously calculated movement distance of the second housing 612 and to perform other operations based on the slide-in speed and/or slide-out speed of the second housing 612. For example, in the case that the slide-in of the second housing 612 is relatively fast performed, the electronic device 600 may be configured to perform a first operation (e.g., end of shooting, turn off alarm) and in the case that slide-in of the second housing 612 is relatively slowly performed, the electronic device 600 may be configured to perform a second operation (e.g., stay in shooting mode, configure an alarm) different from the first operation.

Because the electronic device 600 does not include a magnetic body for measuring a movement distance of the second housing 612, the electronic device 600 may not be affected by a magnetic body outside the same or may not have any effect on an external magnetic body thereof.

The sensor structure 640 and the second support bracket 650 may serve to reinforce strength of the electronic device 600. The electronic device 600 may include a sensor structure 640 and a second support bracket 650; thus, the overall rigidity of the electronic device 600 may be improved.

The second support bracket 650 may include a first part 651 connected to the first support bracket 620, and a second part 652 connected to the second housing 612 and rotatably coupled to the first part 651.

The bending sensor elements 641 and 1210 may include a bending sensor 1211 for measuring an angle of the sensor structures 640 and 1200, and a sensor circuit 1212 for transferring angle information including an angle AG measured by the bending sensor 1211 to the printed circuit board 630.

The sensor circuit 1212 may be electrically connected to the second printed circuit board 630 through the flexible printed circuit board 642.

The second housing 612 may include a groove 6125 including a curved shape guiding a movement of the second support bracket 650.

The second support bracket 650 may guide a movement of the sensor structure 640 so that the sensor structure 640 moves within a predetermined angular range.

The angle AG of the sensor structure 640 may include an angle between an imaginary first straight line T1 parallel to one end portion of the bending sensor element 641 and an imaginary second straight line T2 parallel to the other end portion of the bending sensor element 641.

The sensor structures 640 and 1540 may include straight areas 1540A and 1540B extended in a straight line and a bending area 1540C bent in at least portion, wherein in the straight areas 1540A and 1540B, the bending sensor element 641 and the flexible printed circuit board 642 may be coupled to each other, and in the bending area 1540C, the bending sensor element 641 and the flexible printed circuit board 642 may be spaced from each other.

The flexible printed circuit board 642 may include transfer layers 1440 and 1450 for transferring power and signals.

The bending sensor element 641 may be formed integrally with the flexible printed circuit board 642.

The electronic device 600 may include a battery B disposed in the first support bracket 620.

The flexible printed circuit board 642 may electrically connect the battery B and the second printed circuit board 630.

The second support bracket 650 may include a first pin 6531 for coupling the first part 651 and the second part 652, a second pin 6532 for coupling an end portion of the first part 651 to the support bracket 620, and a third pin 6533 for coupling an end portion of the second part 652 to the second housing 612.

The sensor structure 640 may include a connector 646 for electrically connecting the sensor structure 640 to the second printed circuit board 630.

The electronic device 600 according to an embodiment may include a first housing 210, a second housing 612, a first support bracket 620, a second printed circuit board 630, processors 120 and 1640, and a sensor structure 640.

The processors 120 and 1640 may be disposed in the second printed circuit board 630.

The processors 120 and 1640 may be configured to calculate a distance in which the second housing 612 is moved in a longitudinal direction of the electronic device 600 with respect to the first housing 210 based on the angle of the sensor structure 640.

Bending sensors that use a differential capacitance method for detecting angular displacement of the sensor are commercially available. The elongate sensor element may comprise two flexible capacitors running the length of the sensor element and offset on either side of its centre axis. When bent, the capacitor on the inside of the bend is subject to compressive strain and the capacitor on the outside is subject to tensile strain, leading to a measurable difference in capacitance. For example, when the elongate sensor element is not bent, the differential capacitance is 0, resulting in an angular displacement value, or measured angle, of 0°. As the sensor element is bent, the differential capacitance value and measured angle increases. The differential capacitance measurement may be linearly proportional to the angular displacement of the sensor.

Alternative types of bending (flex) sensors based on other operating principles, for example a change in resistance with bending, are also envisaged. Any type of bending sensor can be used, as long as it is capable of determining a degree of bending.

Technical problems to be addressed in the disclosure are not limited to the above-described technical problems, and other technical problems not described will be clearly understood by those of ordinary skill in the art to which the disclosure belongs.

Effects that can be obtained from the disclosure are not limited to the above-described effects, and other effects not described will be clearly understood by those of ordinary skill in the art to which the disclosure belongs.

An electronic device according to embodiments of the disclosure may be various types of devices. The electronic device may include, for example, a portable communication device (e.g., smart phone), a computer device, a portable multimedia device, a portable medical device, a camera, a wearable device, or a home appliance device. It is not however limited to the above-described devices. It should be understood that an embodiment of the disclosure and terms used therein are not intended to limit the technical features described in the disclosure to specific embodiments, but include various modifications, equivalents, or substitutions of the embodiments. In connection with the description of the drawings, like reference numerals may be used for similar or related components. The singular form of the noun corresponding to the item may include one or more of the item, unless the relevant context clearly dictates otherwise. In the disclosure, each of phrases such as "A or B", "at least one of A and B", "at least one of A or B", "A, B, or C", "at least one of A, B, and C", and "at least one of A, B, or C" may include any one of or all possible combinations of items listed together in the corresponding one of the phrases. Terms such as "first" or "second" may be simply used for distinguishing a corresponding component from other corresponding components, and do not limit the corresponding components in other aspects (e.g., importance or order). In the case that one (e.g., first) component is referred to as "coupled" or "connected" to another (e.g., second) component with or without the terms "functionally" or "communicatively", it means that the one component may be connected to the other component directly (e.g., by wire), wirelessly, or through a third component.

The term "module" used in an embodiment of the disclosure may include a unit implemented in hardware, software, or firmware, and may be used interchangeably with terms such as, for example, logic, logic block, part, or circuit. The module may be an integrally formed part, or a minimum unit or a portion of the part that performs one or more functions. For example, the module may be implemented in the form of an application-specific integrated circuit (ASIC).

Embodiments may be implemented as software (e.g., the program 140) including one or more instructions stored in a storage medium (e.g., the internal memory 136 or the external memory 138) readable by a machine (e.g., the electronic device 101). For example, the processor (e.g., the processor 120) of the device (e.g., the electronic device 101) may call and execute at least one instruction among one or more stored instructions from a storage medium. This makes it possible for the machine to be operated to perform at least one function according to the called at least one instruction. The one or more instructions may include a code generated by a compiler or a code executable by an interpreter. The machine readable storage medium may be provided in the form of a non-transitory storage medium. Here, 'non-transitory' only means that the storage medium is a tangible device and does not include a signal (e.g., electromagnetic wave), and this term does not distinguish the case that data is semi-permanently stored in the storage medium and the case that data is temporarily stored.

A method according to an embodiment may be included and provided in a computer program product. Computer program products may be traded between sellers and buyers as commodities. The computer program product may be distributed in the form of a machine readable storage medium (e.g., compact disc read only memory (CD-ROM)), or may be distributed (e.g., download or upload) via an application store (e.g., Play Store^{™}) or online or directly between two user devices (e.g., smartphones). In the case of online distribution, at least a portion of the computer program product may be at least temporarily stored or temporarily generated in a machine readable storage medium such as a memory of a server of a manufacturer, a server of an application store, or a relay server.

According to an embodiment, each component (e.g., module or program) of the above-described components may include a singular entity or a plurality of entities, and some of the plurality of entities may be separately disposed in other components. According to an embodiment, one or more components or operations among the above-described corresponding components may be omitted, or one or more other components or operations may be added. Alternatively or additionally, a plurality of components (e.g., module or program) may be integrated into one component. In this case, the integrated component may perform one or more functions of each component of the plurality of components identically or similarly to those performed by the corresponding component among the plurality of components prior to the integration.

According to an embodiment, operations performed by a module, program, or other component may be executed sequentially, in parallel, repeatedly, or heuristically, or one or more of the operations may be executed in a different order, or omitted, or one or more other operations may be added.

## Claims

1. An electronic device (610), comprising:
a first housing (210);
a second housing (612) movably coupled to the first housing;
a first support bracket (620) and first printed circuit board (252) disposed in the first housing;
a second printed circuit board (630) disposed in the second housing;
a sensor structure (640) connected to the first support bracket at one end and connected to the second printed circuit board at the other end; and
a second support bracket (650) configured to support the sensor structure,
wherein the sensor structure comprises:
a bending sensor element (641) configured to determine a degree to which the bending sensor element is bent; and
a flexible printed circuit board (642) configured to electrically connect the first printed circuit board and the second printed circuit board, and having at least a portion coupled to the bending sensor element.

2. The electronic device of claim 1, further comprising a processor (1640) disposed in the second printed circuit board,
wherein the processor is configured to calculate a distance by which the second housing moves in a longitudinal direction of the electronic device with respect to the first housing based on the determined degree of bending of the bending sensor element.

3. The electronic device of claim 1 or 2, wherein the second support bracket comprises:
a first part (651) connected to the first support bracket; and
a second part (652) connected to the second housing and rotatably coupled to the first part.

4. The electronic device of claim 3, wherein the second support bracket further comprises:
a first pin (6531) configured to couple the first part (651) and the second part (652);
a second pin (6532) configured to couple an end portion of the first part to the first support bracket; and
a third pin (6533) configured to couple an end portion of the second part to the second housing.

5. The electronic device of any one of the preceding claims, wherein the bending sensor element comprises:
a bending sensor (1211) configured to determine an angle corresponding to a degree of bending of the bending sensor element; and
a sensor circuit (1212) configured to transfer angle information including the angle determined by the bending sensor to the printed circuit board,
wherein the sensor circuit is electrically connected to the second printed circuit board through the flexible printed circuit board.

6. The electronic device of any one of the preceding claims, wherein the second housing comprises a groove (6125) including a curved shape for guiding a movement of the second support bracket.

7. The electronic device of any one of the preceding claims, wherein the second support bracket is configured to guide a movement of the sensor structure so that the sensor structure moves within a predetermined angular range.

8. The electronic device of any one of the preceding claims, wherein the sensor structure comprises:
straight areas (1540A, 1540B) extending in a straight line; and
a bending area (1540C) bent in at least a portion,
wherein in the straight area, the bending sensor element and the flexible printed circuit board are coupled to each other, and
in the bending area, the bending sensor element and the flexible printed circuit board are spaced apart from each other.

9. The electronic device of any one of the preceding claims, wherein the bending sensor element comprises a dielectric layer (1312, 1420, 1430) and a protective layer (1311, 1313, 1410, 1460) protecting the dielectric layer.

10. The electronic device of any one of the preceding claims, wherein the flexible printed circuit board comprises transfer layers (1440, 1450) configured to transfer power and signals.

11. The electronic device of any one of the preceding claims, wherein the bending sensor element is formed integrally with the flexible printed circuit board.

12. The electronic device of any one of the preceding claims, further comprising a battery B disposed in the first support bracket,
wherein the flexible printed circuit board is configured to electrically connect the battery and the second printed circuit board.

13. The electronic device of any one of the preceding claims, wherein the sensor structure comprises a connector (646) configured to electrically connect the sensor structure to the second printed circuit board.

14. The electronic device of any one of the preceding claims, wherein the second support bracket is configured to move according to a movement of the second housing with respect to the first housing.
